(19) Europäisches Patentamt
European Patent Office
Office européen des brevets

(11) Veröffentlichungsnummer: **0 471 650 B1**

# (12) EUROPÄISCHE PATENTSCHRIFT

(45) Veröffentlichungstag der Patentschrift: **03.05.95**

(51) Int. Cl.⁶: **C08G 73/10**, C08G 73/14, G03F 7/038, B01D 71/64, C09D 179/08

(21) Anmeldenummer: **91810624.6**

(22) Anmeldetag: **08.08.91**

## (54) Copolyimide, Verfahren zu deren Herstellung und deren Verwendung.

(30) Priorität: **17.08.90 CH 2674/90**

(43) Veröffentlichungstag der Anmeldung:
**19.02.92 Patentblatt 92/08**

(45) Bekanntmachung des Hinweises auf die Patenterteilung:
**03.05.95 Patentblatt 95/18**

(84) Benannte Vertragsstaaten:
**CH DE FR GB IT LI**

(56) Entgegenhaltungen:
**DE-A- 1 962 588**
**FR-A- 2 050 251**
**FR-A- 2 212 356**

(73) Patentinhaber: **CIBA-GEIGY AG**
**Klybeckstrasse 141**
**CH-4002 Basel (CH)**

(72) Erfinder: **Wernet, Wolfgang, Dr.**
**The Rokko Apt. 301,**
**3-14-12 Shinohara-Kita-muchi**
**Nada-ku,**
**650 Kobe (JP)**
Erfinder: **Berger, Joseph, Dr.**
**Sperrstrasse 40/18**
**CH-4057 Basel (CH)**

EP 0 471 650 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft aromatische Copolyimide aus kernalkylierten aromatischen Diaminen (1) und gegebenenfalls versalzte Sulfonsäuregruppen enthaltenden aromatischen Diaminen (2) und aromatischen Tetracarbonsäuren, ein Verfahren zu deren Herstellung, ein mit den Copolyimiden beschichtetes Material, und die Verwendung der Copolyimide zur Herstellung von Schutzschichten oder Reliefabbildungen oder in Form von semipermeablen Membranen zum Anreichern oder Trennen von Gemischen aus Salzen organischer Carbonsäuren und nicht salzartigen organischen Verbindungen.

In der DE-A-1962588 sind aromatische Polyimide aus Benzophenontetracarbonsäuren und aromatischen ein- oder zweikernigen Diaminen, die $-SO_3H$-Gruppen enthalten können, beschrieben. Die Polyimide sind nur in phenolischen Lösungsmitteln löslich und können zur Herstellung von Lacken verwendet werden.

In der FR-A-2 050 251 werden aromatische Polyimide beschrieben, hergestellt aus $SO_3H$-Gruppen tragenden aromatischen Diaminen die gegebenenfalls in ortho-Stellung zu den Aminogruppen alkylsubstituiert sein können. Sie sind jedoch in organischen Lösungsmitteln weitgehend unlöslich.

In den EP-A-0 132 221, EP-A-0 162 017 und 0 181 837 sind in polaren aprotischen Lösungsmitteln lösliche und autophotopolymerisierbare aromatische Polyimide aus Tetracarbonsäuren, die Benzophenongruppen enthalten, und aromatischen Diaminen, die in den Orthostellungen zu den Aminogruppen mit Alkylgruppen substituiert sind, beschrieben. Sie können zur Herstellung von Schutzschichten oder Reliefabbildungen verwendet werden, wobei die Entwicklung mit einem organischen Lösungsmittel vorgenommen werden muss, was unter ökologischen Gesichtspunkten nachteilig ist.

Es wurde nun überraschend gefunden, dass aromatische Copolyimide aus aromatischen Tetracarbonsäuren und gegebenenfalls aromatischen Tricarbonsäuren und einem ersten aromatischen Diamin sowie einem zweiten aromatischen Diamin, das versalzte $-SO_3H$-Gruppen enthält, wobei das erste und/oder das zweite Diamin in beiden Orthostellungen zu mindestens einer Aminogruppe mit $C_1$-$C_4$-Alkyl substituiert ist, ihre Lichtempfindlichkeit beibehalten und sowohl in polaren aprotischen Lösungsmitteln als auch zusätzlich in wässrig-basischen Medien löslich sind. Sie können daher in einfacher Weise aus organischen Lösungen zum Beispiel zu Filmen, semipermeablen Membranen und Schutzschichten verarbeitet werden. Bei der Herstellung von Reliefabbildungen kann die Entwicklung mit wässrig-basischen Medien vorgenommen werden.

Ein Gegenstand der Erfindung sind Copolyimide mit einer inhärenten Viskosität von 0,2 bis 3,0 dl/g, gemessen bei 25 °C in einer Lösung von 0,5 Gew.-% des Copolyimids in N-Methylpyrrolidon, enthaltend

A) mindestens ein wiederkehrendes Strukturelement aus aromatischen Tetracarbonsäureresten (a) mit 10 bis 30 C-Atomen, die unsubstituiert oder mit Halogen, Nitro, $C_1$-$C_4$-Alkyl, $C_1$-$C_4$-Alkoxy oder Phenacyl substituiert sind, und aromatischen Diaminresten (b) mit 6 bis 30 C-Atomen, die unsubstituiert oder mit $C_1$-$C_4$-Alkyl oder Halogen substituiert sind; und gegebenenfalls zusätzlich mindestens ein wiederkehrendes Strukturelement aus unsubstituierten oder wie (a) substituierten aromatischen Tricarbonsäureresten (c) mit 9 bis 30 C-Atomen und gleichen oder verschiedenen der genannten Diaminreste (b), und

B) mindestens ein wiederkehrendes Strukturelement aus gleichen oder verschiedenen der genannten Tetracarbonsäurereste (a) und aromatischen Diaminresten (d) mit 6 bis 30 C-Atomen, die unsubstituiert oder mit $C_1$-$C_4$-Alkyl substituiert sind, und die mindestens eine an den aromatischen Kern gebundene $-SO_3M$-Gruppe enthalten, worin M für $H^{\oplus}$, ein ein- bis dreiwertiges Metallkation, $NH_4^{\oplus}$ oder ein organisches Ammoniumkation mit 1 bis 30 C-Atomen steht; und gegebenenfalls zusätzlich wiederkehrenden Strukturelementen aus gleichen oder verschiedenen der genannten Tricarbonsäurereste (c) und gleichen oder verschiedenen der besagten Diaminreste (d), mit der Massgabe, dass mindestens einer der Diaminreste (b) oder (d) in beiden Orthostellungen zu mindestens einem N-Atom mit $C_1$-$C_4$-Alkyl substituiert ist.

Bevorzugt sind je beide Orthostellungen zu beiden N-Atomen mit $C_1$-$C_4$-Alkyl substituiert. Besonders bevorzugt sind die Diaminreste (b) oder (d) in beiden Orthostellungen beider N-Atome mit $C_1$-$C_4$-Alkyl substituiert. Ganz besonders bevorzugt sind die Diaminreste (b) und (d) je in beiden Orthostellungen der beiden N-Atome mit $C_1$-$C_4$-Alkyl substituiert. $C_1$-$C_4$-Alkyl kann z.B. n-, i- oder t-Butyl, n- oder i-Propyl und bevorzugt Methyl oder Ethyl sein.

Die Komponente (a) ist bevorzugt zu 5 bis 95 Mol-%, besonders zu 30 bis 95 Mol-% und insbesondere zu 50 bis 95 Mol-%, und die Komponente (b) zu 95 bis 5 Mol-%, besonders zu 5 bis 70 Mol-% und insbesondere zu 50 bis 5 Mol-% enthalten, bezogen auf das Copolyimid.

Die Tricarbonsäurereste (c) können in einer Menge von bis zu 60 Mol-%, bevorzugt bis zu 30 Mol-% und insbesondere bis zu 10 Mol-% enthalten sein, bezogen auf die vorhandenen Säurereste. Bevorzugt sind Copolyimide, die nur Reste von Tetracarbonsäuren enthalten. die inhärente Viskosität beträgt bevorzugt 0,3 bis 2,0 dl/g, besonders 0,3 bis 1,5 dl/g.

Bei den Halogen-Substituenten handelt es sich bevorzugt um F, Cl und Br. Beispiele für die Substituenten $C_1$-$C_4$-Alkyl und $C_1$-$C_4$-Alkoxy sind Methyl, Ethyl, n- oder i-Propyl oder n-, i- oder t-Butyl, Methoxy, Ethoxy, n- oder i-Propoxy oder n-, i- oder t-Butoxy.

Die Tetracarbonsäurereste enthalten bevorzugt 10 bis 24 C-Atome, besonders 10 bis 18 C-Atome, die Tricarbonsäurereste bevorzugt 9 bis 24 C-Atomen, besonders 9 bis 18 C-Atome und die Diaminreste (b) und (d) bevorzugt 6 bis 24 C-Atome und besonders 6 bis 18 C-Atome.

M in der Gruppe $SO_3M$ kann als Ammoniumkation $NH_4^{\oplus}$ oder ein Ammoniumkation eines primären, sekundären oder tertiären offenkettigen Amins mit bevorzugt 1 bis 24, besonders 1 bis 16 C-Atomen bedeuten, oder ein Ammoniumkation eines monocyclischen oder bicyclischen sekundären oder tertiären oder eines tricyclischen tertiären Amins mit bevorzugt 4 bis 12 C-Atomen sein.

M in der Bedeutung eines Metallkations kann ein ein- bis dreiwertiges Kation der Metalle der Haupt- und Nebengruppen, der Uebergangsmetalle und der Edelmetalle sein. Bevorzugt sind ein- oder zweiwertige Metallkationen. Beispiele für Metalle sind Li, Na, K, Rb, Cs, Mg, Ca, Sr, Ba, In, Sn, Pb, Cu, Ag, Au, Zn, Cd, Hg, Cr, Mo, Mn, Fe, Co, Ni, Rn, Rh, Pd, Ir, Pt, Sb, Bi, sowie die Gruppe der Seltene-Erdmetalle. Bevorzugte Metalle sind die Alkali- und Erdalkalimetalle, Cu, Ag, Au, Fe, Co, Ni, Zn, Cd und Mn.

In einer bevorzugten Ausführungsform steht M für $H^{\oplus}$, $NH_4^{\oplus}$, ein Alkalimetallkation oder ein primäres, sekundäres, tertiäres oder quaternäres Ammoniumkation mit 1 bis 24 C-Atomen.

Beispiele für Tri- und Tetracarbonsäuren und Diamine, von denen sich die Reste ableiten, sind z.B. in den EP-A-0 132 221, EP-A-0 162 017 und EP-A-0 181 837 beschrieben. Aromatische Diamine mit $-SO_3M$-Gruppen sind aus der Farbstoffchemie bekannt und teilweise käuflich.

Eine bevorzugte Ausführungsform erfindungsgemässer Copolyimide ist dadurch gekennzeichnet, dass sie

a) Strukturelemente der Formel I

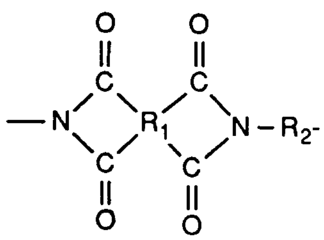

(I)

und gegebenenfalls zusätzlich Strukturelemente der Formel II

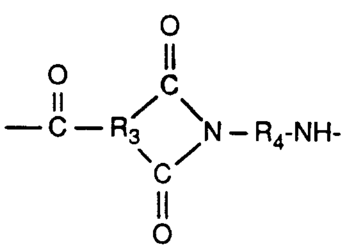

(II),

und

b) Strukturelemente der Formel III

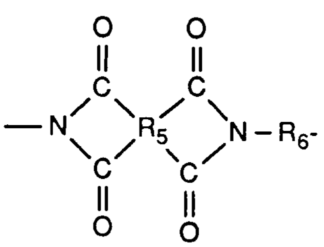

(III)

und gegebenenfalls zusätzlich Strukturelemente der Formel IV

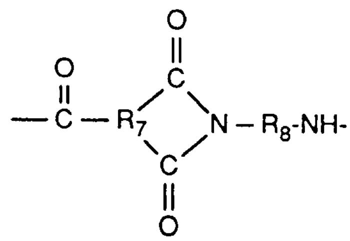

(IV)

enthalten, worin

$R_1$ und $R_5$ unabhängig voneinander einen unsubstituierten oder substituierten vierwertigen aromatischen Rest mit 6 bis 20 C-Atomen darstellen, an den je zwei der Carbonylgruppen in Ortho- oder Peristellung gebunden sind,

$R_3$ und $R_7$ unabhängig voneinander einen unsubstituierten oder substituierten trivalenten aromatischen Rest mit 6 bis 20 C-Atomen bedeuten, an den zwei Carbonylgruppen in Ortho- oder Peristellung gebunden sind,

$R_2$ und $R_4$ unabhängig voneinander einen zweiwertigen aromatischen Kohlenwasserstoffrest mit 6 bis 20 C-Atomen darstellen, der unsubstituiert oder mit $C_1$-$C_4$-Alkyl oder Halogen substituiert ist, und

$R_6$ und $R_8$ unabhängig voneinander einen zweiwertigen aromatischen Kohlenwasserstoffrest mit 6 bis 20 C-Atomen, die unsubstituiert oder mit $C_1$-$C_4$-Alkyl substituiert sind und die mindestens eine $-SO_3M$-Gruppe enthalten, worin M für $H^{\oplus}$, ein ein- bis dreiwertiges Metallkation, $NH_4^{\oplus}$ oder ein organisches Ammoniumkation mit 1 bis 30 C-Atomen steht, mit der Massgabe, dass die Reste $R_2$ und $R_4$ und/oder die Reste $R_6$ und $R_8$ in beiden Orthostellungen zu mindestens einem N-Atom mit $C_1$-$C_4$-Alkyl substituiert sind.

Bevorzugt sind solche Copolyimide, worin $R_1$ und $R_5$ unabhängig voneinander Reste der Formeln

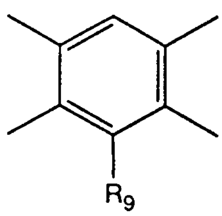 , 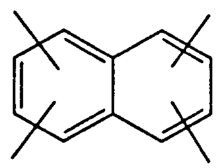 , 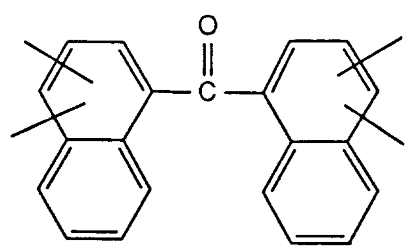 ,

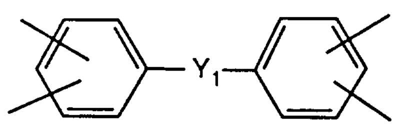 , 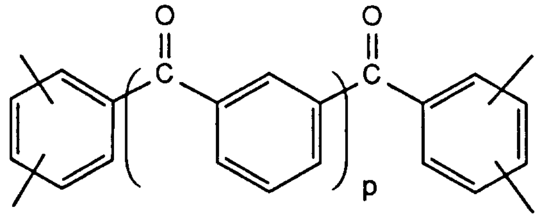 oder

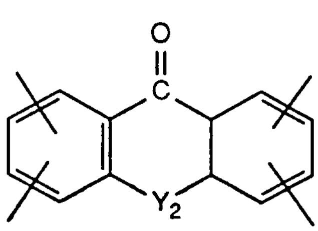

bedeuten, worin je zwei Bindungen in Orthostellung zueinander stehen, $R_9$ H oder Phenacyl darstellt, $Y_1$ für eine direkte Bindung, $-CH_2-$, $-CH(CH_3)-$, $-C(CH_3)_2-$, -O-, -S-, -SO-, $-SO_2-$, -C(O)O- oder $-NR_{10}-$ steht, p 0 oder 1 bedeutet, $Y_2$-$CH_2-$, $-CH(CH_3)-$, $-C(CH_3)_2-$, -O-, -S-,-SO-, $-SO_2-$,-CO- oder $-NR_{10}-$ darstellt, und $R_{10}$

für H oder $C_1$-$C_6$-Alkyl steht.

Besonders bevorzugt sind solche Copolyimide, worin $R_1$ und $R_5$ unabhängig voneinander Reste der Formeln

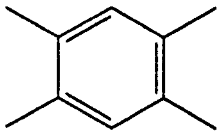 , 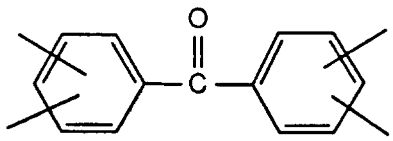 , 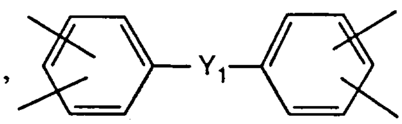 oder

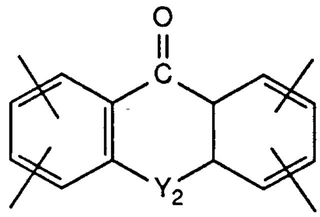

darstellen, worin je 2 Bindungen in Orthostellung zueinander stehen, $Y_1$ eine direkte Bindung, $-CH_2-$, -O-, -S- oder $-SO_2-$, bedeutet und $Y_2$ eine direkte Bindung -O-, -S- oder -CO- darstellt.

Insbesondere bevorzugt stellen $R_1$ und $R_5$ tetravalente Reste von Pyrromellitsäure, Benzophenontetracarbonsäure und Thioxanthontetracarbonsäure dar.

$R_3$ und $R_7$ bedeuten bevorzugt unabhängig voneinander Reste der Formeln

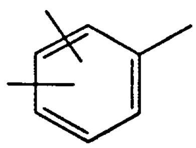 oder 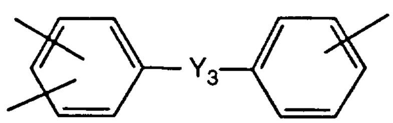

worin zwei Bindungen in Orthostellung zueinander gebunden sind und $Y_3$ für eine direkte Bindung, -S-, -O-, $-CH_2-$ oder -CO- steht.

Eine weitere bevorzugte Ausführungsform ist dadurch gekennzeichnet, dass die Tetracarbonsäurereste $R_1$ und $R_5$ und die Tricarbonsäurereste $R_3$ und $R_7$ eine Benzophenongruppe enthalten.

Bei den Resten $R_2$. $R_4$, $R_6$ und $R_8$ handelt es sich bevorzugt um einen Phenylenrest, Naphthylenrest oder um einen gegebenenfalls verbrückten Biphenylenrest.

Eine bevorzugte Ausführungsform erfindungsgemässer Copolyimide ist dadurch gekennzeichnet, dass $R_2$ und $R_4$ unabhängig voneinander einen unsubstituierten oder mit Cl, Br oder $C_1$-$C_4$-Alkyl substituierten Rest der Formeln

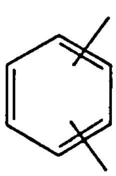 , 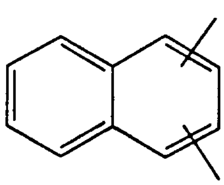 , 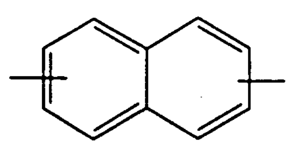 , 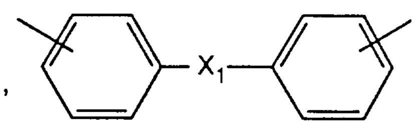

bedeuten, worin $X_1$ für eine direkte Bindung $-CH_2-$, $-(CH_2)_2-$, -HC=CH-, $CH_3CH\langle$ , $(CH_3)_2C\langle$ , $-NR_{10}-$, -N=N-, -CO-, -O-, -S-, -SO- oder $-SO_2$ steht, und $R_{10}$ H oder $C_1$-$C_6$-Alkyl bedeutet und

$R_6$ und $R_8$ unabhängig voneinander einen Rest der Formeln

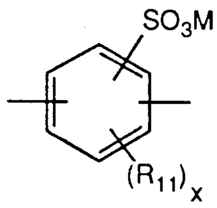 , 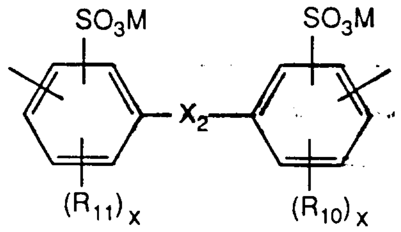

darstellen, worin $X_2$ unabhängig die gleiche Bedeutung wie $X_1$ hat, $R_{11}$ für $C_1$-$C_4$-Alkyl steht, x für 0, 1, 2 oder 3 steht und M für $H^{\oplus}$, $NH_4^{\oplus}$, ein Alkalimetallkation oder ein primäres, sekundäres, tertiäres oder quaternäres Ammoniumkation mit 1 bis 24 C-Atomen steht.

Besonders bevorzugte Copolyimide sind dadurch gekennzeichnet, dass es sich um ein Copolyimid mit Strukturelementen der Formeln I und III handelt, und $X_1$ und $X_2$ unabhängig voneinander eine direkte Bindung, $-CH_2-$, -CH=CH-, -CO-, -O- oder -S-bedeuten.

Eine besonders bevorzugte Gruppe von Copolyimiden ist dadurch gekennzeichnet, dass in den Strukturelementen der Formeln I und III des Copolyimids $R_1$ und $R_5$ unabhängig voneinander für einen unsubstituierten oder mit Phenacyl, $-NO_2-$, -Cl oder -Br substituierten vierwertigen Benzolrest oder Reste der Formeln

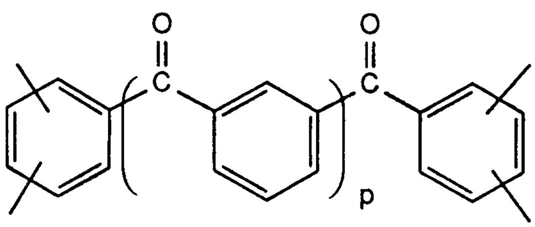 oder 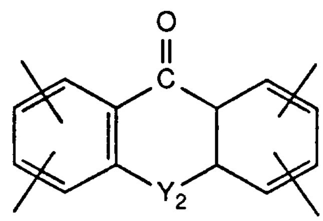

stehen, worin p für 0 oder 1 steht und $Y_2$ eine direkte Bindung, $-CH_2-$, -S-, -O- oder -CO-darstellen, $R_2$ in beiden Orthostellungen zu mindestens einer Aminogruppe mit Methyl und/oder Ethyl substituiertes 1,3- oder 1,4-Phenylen oder in beiden o-Stellungen zu den Aminogruppen mit Methyl und/oder Ethyl substituiertes 3,3'- oder 4,4'-Diphenylmethandiyl bedeutet, und $R_6$ einen Rest der Formeln

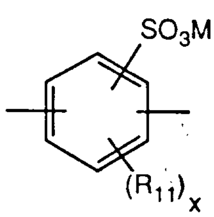 , 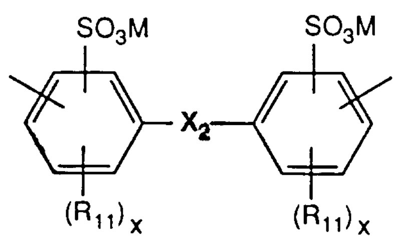

darstellt, worin $X_2$ eine direkte Bindung, -CH=CH- oder $-CH_2-$ bedeutet, $R_{11}$ für Methyl und/oder Ethyl steht, x für 0, 1, 2 oder 3 steht, und M für $H^{\oplus}$, $NH_4^{\oplus}$, $Li^{\oplus}$, $Na^{\oplus}$, $K^{\oplus}$, $Rb^{\oplus}$, $Cs^{\oplus}$ primäres, sekundäres, tertiäres oder quaternäres Ammonium mit 1 bis 20 C-Atomen steht.

Ganz besonders bevorzugte Copolyimide sind dadurch gekennzeichnet, dass $R_6$ ein Rest der Formeln

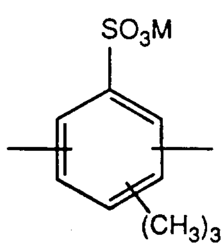 oder 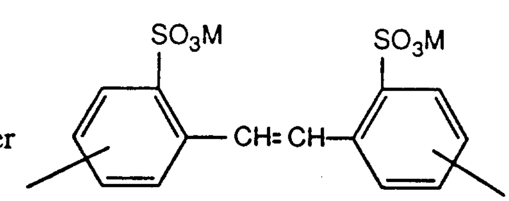

ist, worin M für $H^{\oplus}$, $NH_4^{\oplus}$, $Li^{\oplus}$, $Na^{\oplus}$, $K^{\oplus}$, $Rb^{\oplus}$, $Cs^{\oplus}$, tertiäres oder quaternäres Ammonium mit 4 bis 20 C-Atomen steht.

Ein weiterer Gegenstand der Erfindung ist ein Verfahren zur Herstellung von Copolyimiden gemäss Anspruch 1, das dadurch gekennzeichnet ist, dass man,

A) mindestens eine aromatischen Tetracarbonsäure (a') mit 10 bis 30 C-Atomen, die unsubstituiert oder mit Halogen, Nitro, $C_1$-$C_4$-Alkyl, $C_1$-$C_4$-Alkoxy oder Phenacyl substituiert ist, und gegebenenfalls mindestens eine aromatische Tricarbonsäure (c') mit 9 bis 30 C-Atomen, die unsubstituiert oder wie (a') substituiert ist, oder deren Polyimid bildenden Derivate

B) mit mindestens einem aromatischen Diamin (b') mit 6 bis 30 C-Atomen, das unsubstituiert oder mit $C_1$-$C_4$-Alkyl oder Halogen substituiert ist, und und mit mindestens einem aromatischen Diamin (d') mit 6 bis 30 C-Atomen, das unsubstituiert oder mit $C_1$-$C_4$-Alkyl substituiert ist, und das mindestens eine an den aromatischen Kern gebundene -$SO_3$M-Gruppe enthält, mit der Massgabe, dass mindestens eines der Diamine (b') oder (d') in beiden Orthostellungen zu mindestens einer Aminogruppe mit $C_1$-$C_4$-Alkyl substituiert ist, umsetzt und cyclisiert.

Säurederivate sind z.B. Anhydride, Ester, Amide und Halogenide, besonders Chloride. Die im Verfahren verwendeten Monomeren sind bekannt, teilweise käuflich oder nach bekannten Verfahren herstellbar.

Die Herstellung der Polyimide wird vorteilhaft in Lösung durchgeführt; geeignete inerte Lösungsmittel sind nachfolgend genannt. Die Reaktionstemperaturen können -20 bis 300 °C betragen.

Im einzelnen geht man zweckmässig so vor, dass man Tetracarbonsäuredianhydrid und Diamin zunächst unter Bildung einer Polyamidsäurevorstufe umsetzt und diese Polyamidsäure anschliessend unter Wasserabspaltung cyclisiert. Die Cyclisierung kann thermisch erfolgen. Vorteilhaft wird die Cyclisierung unter Einwirkung von wasserentziehenden Mitteln, z.B. Carbonsäureanhydriden wie Acetanhydrid, vorgenommen. Die Polyimide können anschliessend nach üblichen Verfahren, z.B. durch Entfernen des Lösungsmittels oder Ausfällen durch Zugabe eines Nichtlösungsmittels, isoliert werden.

Eine weitere Herstellungsmethode besteht darin, dass man das Tetracarbonsäuredianhydrid mit einem Diisocyanat in einer Stufe zum Polyimid umsetzt.

Aus den erfindungsgemässen Copolyimiden können nach bekannten Verfahren semipermeable Membrane hergestellt werden, mit denen überraschend organische Stoffgemische getrennt bzw. Einzelbestandteile angereichert werden können.

Ein weiterer Gegenstand der Erfindung ist ein Verfahren zum Anreichern oder Trennen von Salzen organischer Carbonsäuren von nicht salzartigen organischen Verbindungen mit einer semipermeablen Membran, das dadurch gekennzeichnet ist, dass man eine Lösung der Salze und organischen Verbindungen in einem unsubstituierten oder mit $C_1$-$C_3$-Alkoxy substituierten $C_1$-$C_4$-Alkanol, Mischungen solcher Alkanole oder Mischungen solcher Alkanole mit Ethern mit einer Seite der Membran in Berührung bringt, wobei sich auf der Gegenseite der Membran das reine Lösungsmittel befindet, und die Membran aus einem erfindungsgemässen Copolyimid besteht und die Verwendung von erfindungsgemässen Copolyimiden in Form von semipermeablen Membranen zum Anreichern oder Trennen von Salzen organischer Carbonsäuren von nichtsalzartigen organischen Verbindungen.

Die Konzentration der Salze und organischen Verbindungen beträgt bevorzugt 0,0001 bis 10, besonders 0,001 bis 5 und insbesondere 0,001 bis 3 Gewichtsprozent, bezogen auf die Lösung.

Die Dicke der Membran kann z.B. 5 bis 300 $\mu$m, bevorzugt 20 bis 200 $\mu$m betragen.

Das als Lösungsmittel verwendete Alkanol enthält 1 bis 4 C-Atome und bevorzugt 1 bis 3 C-Atome. Es kann z.B. mit Methoxy oder Ethoxy substituiert sein. Beispiele sind Methanol, Ethanol, n- und i-Propanol, n-, i- und t-Butanol, Methoxyethanol, Ethoxyethanol, Propoxyethanol, 1-Methoxy-propan-3-ol, 2-Methoxy-propan-1-ol. Bevorzugte Lösungsmittel sind Methanol, Ethanol, 1- oder 2-Propanol und 2-Methoxyethanol. Es können auch Mischungen der Alkanole untereinander oder mit Ethern, z.B. Diethylether oder Ethylenglykoldimethylether verwendet werden.

Bei dem Salz der organischen Carbonsäure kann es sich um Ammonium- oder Metallsalze handeln, z.B. $NH_4^{\oplus}$, einem Ammoniumkation eines primären, sekundären oder tertiären Amins mit insgesamt 1 bis 20 C-Atomen, Alkalimetallsalze und Erdalkalimetallsalze. Bevorzugt sind Alkalimetallsalze und Ammoniumsalze. Besonders bevorzugt sind $NH_4^{\oplus}$- und $Li^{\oplus}$-Salze.

Bei der organischen Carbonsäure kann es sich z.B. um Mono-, Di-, Tri- oder Tetracarbonsäuren handeln. Bevorzugt sind aliphatische, cycloaliphatische, aromatische und heterocyclische oder heteroaromatische Monocarbonsäuren, die 1 bis 18 C-Atome, vorzugsweise 1 bis 12 C-Atome enthalten.

Eine bevorzugte Ausführungsform ist dadurch gekennzeichnet, dass die organische Säure der Formel (A)

$R_a$-X-COOH (A)

entspricht, worin X eine direkte Bindung, $C_1$-$C_4$-Alkylen, $C_2$-$C_4$-Alkyliden oder $C_2$-$C_4$-Alkenylen bedeutet, $R_a$ für H, $C_1$-$C_{12}$-Alkyl, $C_2$-$C_{12}$-Alkenyl, $C_2$-$C_{12}$-Alkinyl, $C_3$-$C_{12}$-Cycloalkyl, $C_3$-$C_{12}$-Cycloalkenyl, $C_6$-$C_{16}$-Aryl, $C_3$-$C_{12}$-Heterocycloalkyl, $C_3$-$C_{12}$-Heterocycloalkenyl, $C_6$-$C_{16}$-Heteroaryl steht, die unsubstituiert oder mit -OH, -SH, -CN, -$NO_2$, Halogen, $C_1$-$C_6$-Alkyl, $C_1$-$C_6$-Alkoxy, $C_1$-$C_6$-Alkylthio, $C_1$-$C_6$-Alkyl-Y- mit Y gleich -CO-, -SO-, -$SO_2$-, -CO-O-, -O-CO-, -CO-$NR_bR_c$-, -$NR_4R_5$-CO- substituiert sind, und $R_b$ und $R_c$ unabhängig voneinander H, $C_1$-$C_6$-Alkyl, $C_2$-$C_4$-Hydroxyalkyl oder $R_b$ und $R_c$ zusammen Tetramethylen, Pentamethylen oder 3-Oxapentyl-1,4-en darstellen.

Beispiele für $R_a$ als Alkyl, das linear oder verzweigt sein kann, sind Methyl, Ethyl, n- und i-Propyl, n- und i-Butyl, Pentyl, Hexyl, Heptyl, Octyl, Nonyl, Decyl, Undecyl und Dodecyl.

Beispiele für $R_a$ als Alkenyl, das linear oder verzweigt sein kann, sind Vinyl, Crotonyl, Allyl, But-1-en-1-yl, But-1-en-2-yl, But-1-en-3-yl, But-1-en-4-yl, But-2-en-1-yl, But-2-en-2-yl, But-2-en-4-yl, Pentenyl, Hexenyl, Heptenyl, Octenyl, Nonenyl, Decenyl, Undecenyl und Dodecenyl.

Beispiele für $R_a$ als Alkinyl, das linear oder verzweigt sein kann, sind Ethinyl, Prop-2-in-1-yl, Prop-2-in-3-yl, Butinyl, Pentinyl, Hexinyl, Heptinyl, Octinyl, Decinyl und Dodecinyl.

$R_a$ enthält als Cycloalkyl und Cycloalkenyl bevorzugt 4-8 C-Atome, besonders 5 oder 6 C-Atome. Beispiele sind Cyclopropyl und Cyclopropenyl, Cyclobutyl und Cyclobutenyl, Cyclopentyl und Cyclopentenyl, Cyclohexyl und Cyclohexenyl, Cycloheptyl und Cycloheptenyl, Cyclooctyl und Cyclooctenyl.

$R_a$ enthält als Aryl bevorzugt 6 bis 12 C-Atome. Einige Beispiele sind Phenyl, Biphenyl und Naphthyl.

$R_a$ enthält als Heterocycloalkyl und Heterocycloalkenyl bevorzugt 4 bis 8, besonders 4 bis 6 Ring-C-Atome. Bevorzugte Heteroatome sind solche aus der Gruppe O, S und $NR_d$, worin $R_d$ H, $C_1$-$C_6$-Alkyl oder $C_1$-$C_7$-Acyl bedeutet. $R_a$ enthält als Heteroaryl bevorzugt 4 bis 11 Ring-C-Atome und bevorzugt Heteroatome aus der Gruppe O, S und -N=. Einige Beispiele für Heterocyclen sind Pyrrolidin, Tetrahydrofuran, Tetrahydrothiophen, Pyrrolin, Dihydrofuran, Dihydrothiophen, Indan, Dihydrocumaron, Dihydrobenzothiophen, Carbazol, Dibenzofuran, Dibenzothiophen, Pyrazolidin, Imidazolidin, Pyrazolin, Imidazolin, Benzimidazolidin, Oxazolidin, Oxazolin, Thiazolidin, Thiazolin, Isooxazolidin, Isooxazolin, Isothiazolidin, Isothiazolin, Benzoxazolidin, Benzisooxazolidin, Benzthiazolidin, 1,2,3- oder 1,2,4-Triazolidin, 1,2,3- oder 1,2,4-Triazolin, 1,2,3- oder 1,2,4-Oxazolidin oder -Oxazolin, Piperidin, Di- und Tetrahydropyridin, Dihydro- und Tetrahydropyran, Di- und Tetrahydrothiopyran, Piperazin, Dehydropiperazin, Morpholin, Thiomorpholin, 1,3- und 1,4-Dioxan, 1,4-Dithian, Azepan, 1,3-Dioxolan, 1,3-Dithiolan, Pyrrol, Indol, Imidazol, Benzimidazol, Furan, Thiophen, Benzofuran, Benzothiophen, Carbazol, Dibenzofuran, Dibenzothiophen, Oxazol, Isooxazol, Thiazol, Isothiazol, Benzoxazol, Benzothiazol, Pyridin, Pyrimidin, Pyrazin, Pyridazin, Chinolin, Isochinolin, Acridin, Chromen, Chroman, Pyran, Thiapyran, Phenazin, Phenoxazin, Phenolthiazin, Purin.

Beispiele für $R_b$, $R_c$ und $R_d$ als Alkyl und Hydroxyalkyl sind Methyl, Ethyl, Propyl, Butyl, 2-Hydroxyethyl, 2- oder 3-Hydroxypropyl, 2-, 3- oder 4-Hydroxybutyl. Beispiele für $R_d$ als Acyl sind Acetyl, Propionyl und Phenacyl.

Beispiele für X in Formel A sind Methylen, Ethylen, 1,2- oder 1,3-Propylen, 1,2-, 1,3- oder 1,4-Butylen, Ethyliden, 1,1- oder 2,2-Propyliden, 1,1- oder 2,2-Butyliden, Ethenylen, Prop-1-en-1,3- oder -1,2- oder -2,3-ylen.

Eine bevorzugte Ausführungsform ist dadurch gekennzeichnet, dass es sich bei dem Salz um $Li^{\oplus}$- oder $NH_4^{\oplus}$-Salze von Carbonsäuren aus der Gruppe Furan-2-carbonsäure, Benzoesäure, Methylbenzoesäure, Phenylessigsäure, Zimtsäure, Sorbinsäure oder $C_2$-$C_8$-Alkancarbonsäuren handelt.

Die nicht salzartige organische Verbindung enthält bevorzugt 2 bis 20, besonders 2 bis 16 und insbesondere 2 bis 12 C-Atome. Insbesondere ist die organische Verbindung ein Ester einer organischen Monocarbonsäure mit insgesamt 2 bis 16 C-Atomen, ein Ether mit 2 bis 12 C-Atomen, ein Keton mit 3 bis 16 C-Atomen oder ein Alkohol mit 5 bis 16 C-Atomen.

Eine bevorzugte Ausführungsform ist dadurch gekennzeichnet, dass die organische Verbindung ein $C_1$-$C_6$-Alkylester von Furan-2-carbonsäure, Benzoesäure, Methylbenzoesäure, Phenylessigsäure, Zimtsäure, Sorbinsäure oder $C_2$-$C_8$-Alkancarbonsäuren; ein $C_5$-$C_{12}$-Alkanol oder Benzylalkohol; ein dialiphatisches Keton mit 3 bis 10 C-Atomen, ein $C_1$-$C_6$-Alkyl-phenylketon oder Diphenylketon; oder ein dialiphatischer Ether mit 2 bis 8 C-Atomen, $C_1$-$C_6$-Alkyl-phenylether oder Diphenylether ist.

Die Membran kann zur Durchführung des erfindungsgemässen Verfahrens in verschiedenen Formen ausgebildet und in Trennmodulen üblicher Bauart eingebaut sein. So kann man z.B. Flachmembranen oder asymmetrische Membranen zu Zwei- oder Mehrkammersystemen kombinieren. Man kann auch schlauchförmige Membranen oder Hohlfasern verwenden, die im allgemeinen in Form von Bündeln eingesetzt werden. Zur Erhöhung der mechanischen Stabilität können die Membranen auf ein Stützgerüst aufgebracht werden. Die Herstellung der Membranen erfolgt nach bekannten Verfahren. Mit einer Photovernetzung kann die mechanische Stabilität ebenfalls erhöht werden.

Die erfindungsgemässen Verfahren werden im allgemeinen bei Raumtemperatur durchgeführt. Zur Erzielung ausreichender Fliessgeschwindigkeit ist es vorteilhaft, auf der Seite der Lösung einen erhöhten Druck einzustellen. Der Druck beträgt bevorzugt 1 bis 10 MPa, besonders bevorzugt 1 bis 6 MPa. In einer besonderen Ausführungsform wird das Verfahren nach dem Gegenstromprinzip durchgeführt.

Das erfindungsgemässe Verfahren kann zum Beispiel als Anreicherungs- oder Reinigungsverfahren oder zur Rückgewinnung bzw. Abtrennung von Reaktionskomponenten oder Nebenprodukten aus Reaktionsrückständen oder Reaktionsgemischen eingesetzt werden oder zur Isolierung bzw. Reinigung von Zwischenprodukten verwendet werden, besonders wenn es sich um thermisch labile Substanzen handelt.

Bei den erfindungsgemässen Copolyimiden handelt es sich um Polymere mit hohen Glasumwandlungstemperaturen und hoher Thermostabilität, die direkt durch Einwirkung von Strahlung vernetzt werden können. Sie eignen sich zur Herstellung von Folien, Fasern und zur Beschichtung von Substraten, für den Oberflächenschutz oder zur Erzeugung von Reliefabbildungen, wobei durch Bestrahlung die Eigenschaften der Copolyimide modifiziert werden können. Die hochschmelzenden aromatischen Copolyimide werden bevorzugt aus Lösung verarbeitet.

Die Strahlungsempfindlichkeit ist dann besonders hoch, wenn die Säurekomponenten der erfindungsgemässen Copolyimide Benzophenongruppen enthalten. Zur Erzielung kurzer Bestrahlungszeiten werden bevorzugt Copolyimide mit solchen Säurekomponenten der Einwirkung von Strahlung ausgesetzt.

Ein bevorzugter Anwendungsbereich ist die Verwendung zur Beschichtung von Oberflächen und die Herstellung von Reliefabbildungen auf solchen beschichteten Substraten, was ein weiterer Gegenstand vorliegender Erfindung ist. Es ist besonders vorteilhaft, dass zur Erzielung gewünschter Eigenschaften die erfindungsgemässen Copolyimide für bestimmte Anforderungen bei der Anwendung durch Auswahl unterschiedlicher Monomerer und/oder durch Abmischung verschiedener Copolyimide entsprechend eingestellt werden können. Ein weiterer besonderer Vorteil der erfindungsgemässen Copolyimide ist deren Löslichkeit in wässrig-basischen Medien, z.B. in wässrigen Alkalimetallhydroxidlösungen (z.B. NaOH oder KOH) oder z.B. in wässrigen Alkalimetallcarbonatlösungen (z.B. $NaHCO_3$, $Na_2CO_3$, $KHCO_3$ oder $K_2CO_3$).

Ein weiterer Gegenstand der Erfindung ist ein beschichtetes Material, enthaltend auf einem Träger eine Schicht eines erfindungsgemässen Copolyimids.

Zur Herstellung des erfindungsgemässen beschichteten Materials löst man ein Copolyimid oder Gemische davon zweckmässig in einem geeigneten organischen Lösungsmittel, gegebenenfalls unter Erwärmen. Geeignete Lösungsmittel sind z.B. polare, aprotische Lösungsmittel, die alleine oder in Mischungen aus mindestens zwei Lösungsmitteln verwendet werden können. Beispiele sind: Ether wie Dibutylether, Tetrahydrofuran, Dioxan, Ethylenglykol, Dimethylethylenglykol, Dimethyldiethylenglykol, Diethyldiethylenglykol, Dimethyltriethylenglykol, halogenierte Kohlenwasserstoffe wie Methylenchlorid, Chloroform, 1,2-Dichlorethan, 1,1,1-Trichlorethan, 1,1,2,2-Tetrachlorethan, Carbonsäureester und Lactone wie Essigsäureethylester, Propionsäuremethylester, Benzoesäureethylester, 2-Methoxyethylacetat, γ-Butyrolacton, o-Valerolacton und Pivalolacton, Carbonsäureamide und Lactame wie Formamid, Acetamid, N-Methylformamid, N,N-Dimethylformamid, N,N-Dimethylformamid, N,N-Dimethylacetamid, N,N-Diethylacetamid, γ-Butyrolactam, ε-Caprolactam, N-Methylpyrrolidon, N-Acetylpyrrolidon, N-Methylcaprolactam, Tetramethylharnstoff, Hexamethylphosphorsäuretriamid, Sulfoxide wie Dimethylsulfoxid, Sulfone wie Dimethylsulfon, Diethylsulfon, Trimethylensulfon, Tetramethylensulfon, Trimethylamin, Triethylamin, N-Methylpyrrolidin, N-Methylpiperidin, N-Methylmorpholin, substituierte Benzole wie Chlorbenzol, Nitrobenzol, Phenole oder Kresol.

Ungelöste Anteile können durch Filtration, bevorzugt einer Druckfiltration, entfernt werden. Die Konzentration an Copolyimid im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung. Die Lösungen sind lagerstabil, müssen aber vor Lichteinwirkung geschützt werden.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren, Farbstoffe, Pigmente und Haftvermittler. Ferner können auch, falls erwünscht, zusätzlich Sensibilisatoren, wie z.B. Thioxanthonderivate oder Benzophenonderivate einverleibt werden, um die Lichtempfindlichkeit noch weiter zu erhöhen.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate bzw. Trägermaterialien, aufgebracht werden. Geeignete Substrate sind z.B. Kunststoffe, Metalle und Metalllegierungen, Halbmetalle, Halbleiter, Glas, Keramik und andere anorganische Materialien wie z.B. $SiO_2$ und $Si_3N_4$. Danach wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis zu ca. 500 µm und mehr, bevorzugt von 0,5 bis 500 µm und besonders von 1 bis 50 µm

aufweisen.

Die strahlungsempfindliche Schicht im erfindungsgemässen Material kann durch Einwirkung von Strahlung vernetzt werden.

Die Photostrukturierung bzw. Photovernetzung kann durch energiereiche Strahlung hervorgerufen werden, z.B. durch Licht insbesondere im UV-Bereich, durch Röntgenstrahlen, Laserlicht, Elektronenstrahlen usw. Das erfindungsgemässe Material eignet sich hervorragend zur Herstellung von Schutzfilmen, Passivierlacken, und als photographisches Aufzeichnungsmaterial für thermostabile Reliefabbildungen.

Anwendungsgebiete sind z.B. Schutz-, Isolier- und Passivierlacke in der Elektrotechnik und Elektronik, Photomasken für die Elektronik, den Textildruck und das graphische Gewerbe, Aetzresiste zur Herstellung gedruckter Schaltungen und Druckplatten und integrierter Schaltkreise, Relais für die Herstellung von Röntgenmasken, als Lötstoplack, als Dielektrikum für Mehrlagenschaltungen, als Strukturelement für Flüssigkristallanzeiger.

Die Herstellung von Schutzfilmen erfolgt durch direktes Belichten, wobei sich die Belichtungszeiten im wesentlichen nach den Schichtdicken und der Lichtempfindlichkeit richten.

Die photographische Erzeugung der Reliefstruktur erfolgt durch bildmässige Belichtung durch eine Photomaske, anschliessende Entwicklung unter Entfernung der unbelichteten Anteile mit einem wässrig-basischen Medium, besonders wässrigen Alkalimetallhydroxidlösungen (NaOH, KOH), wonach gegebenenfalls das erzeugte Bild durch eine thermische Nachbehandlung stabilisiert werden kann.

Ein weiterer Gegenstand der Erfindung ist ein Verfahren zur Herstellung von Schutzschichten oder Reliefabbildungen, das dadurch gekennzeichnet ist, dass man die Schicht des Materials flächenmässig bestrahlt, oder unter einer Photomaske bestrahlt und danach in einem wässrig-basischen Medium durch Lösen der unbestrahlten Anteile entwickelt.

Ein weiterer Gegenstand der Erfindung ist die Verwendung der erfindungsgemässen Copolyimide zur Herstellung von Schutzschichten oder Reliefabbildungen.

Die Polymerschicht des erfindungsgemässen Materials weist eine für viele Anwendungszwecke ausreichende und teilweise hohe Lichtempfindlichkeit auf und sie kann direkt photovernetzt werden. Die Schutzfilme und Reliefabbildungen zeichnen sich durch gute Haftfestigkeit und thermische, mechanische und chemische Widerstandsfähigkeit aus. Bei thermischen Nachbehandlungen wird nur ein geringer Schwund beobachtet. Ferner können Zusätze zur Erzeugung bzw. Steigerung der Lichtempfindlichkeit vermieden werden. Das Material ist lagerstabil, ist aber vor Lichteinwirkung zu schützen.

Die nachfolgenden Beispiele erläutern die Erfindung näher.

A) Herstellung der Copolymeren

Beispiele A1-A14:

In einem 200 ml Glaskolben mit Rührer, Rückflusskühler, Tropftrichter, Trockenrohr und Kühlbad werden die Diamine in N-Methylpyrrolidon (NMP) gelöst vorgelegt. Die Lösung wird auf 5 °C gekühlt und dann werden während 15 Minuten bei kräftigem Rühren die Tetracarbonsäureanhydride zugetropft, so dass eine 20 gewichtsprozentige Lösung entsteht. Die Lösung wird weitere 4 Stunden bei 20 bis 25 °C gerührt. Darauf wird die entstandene Polyamidsäure durch Zugabe von Triethylamin und Essigsäureanhydrid cyclisiert. Nach weiteren 12 h Rühren wird in Wasser gefällt, der Niederschlag abfiltriert, mit Methanol gewaschen und im Hochvakuum bei 40 °C getrocknet. Weitere Angaben befinden sich in der nachfolgenden Tabelle 1.

Tabelle 1:

| Beispiel Nr. | Diamin 1[1] (Mol-%) | Diamin 2[1] (Mol-%) | Tetracarbonsäure-dianhydrid | Inhärente[2] Viskosität (dl/g) | $T_g$[3]/ $T_m$[4] (°C) |
|---|---|---|---|---|---|
| A1 | Tetramethyl-p-phenylendiamin (95) | 3,5-Diamino-2,4,6-trimethylbenzol-1-sulfonsäure-tetra-butylammoniumsalz (5) | 3,4,3',4'-Benzophenon-tetracarbonsäuredi-anhydrid | 0,88 | - / 385 |
| A2 | Tetramethyl-p-phenylendiamin (80) | 3,5-Diamino-2,4,6-trimethylbenzol-1-sulfonsäure-tetra-butylammoniumsalz (20) | 3,4,3',4'-Benzophenon-tetracarbonsäuredi-anhydrid | 0,81 | - / 392 |
| A3 | Tetramethyl-p-phenylendiamin (90) | 3,5-Diamino-2,4,6-trimethylbenzol-1-sulfonsäure-tetra-butylammoniumsalz (10) | 3,4,3',4'-Benzophenon-tetracarbonsäuredi-anhydrid | 0,83 | - / - |
| A4 | Tetramethyl-p-phenylendiamin (90) | 4,4'-Diamino-trans-stilben-2,2'-di-sulfonsäure-di-tetra-butylammoniumsalz (10) | 3,4,3',4'-Benzophenon-tetracarbonsäuredi-anhydrid | 0,88 | - / 397 |

Tabelle 1: Fortsetzung

| Beispiel Nr. | Diamin 1[1] (Mol-%) | Diamin 2[1] (Mol-%) | Tetracarbonsäure-dianhydrid | Inhärente[2] Viskosität (dl/g) | $T_g$[3]/ $T_m$[4] (°C) |
|---|---|---|---|---|---|
| A5 | 4,4'-Diamino-3,3'-dimethyl-5,5'-diethyl-diphenylmethan (80) | 3,5-Diamino-2,4,6-trimethylbenzol-1-sulfonsäure-tetrabutylammoniumsalz (20) | Pyrromellitsäure-dianhydrid | 0,78 | - |
| A6 | 4,4'-Diamino-3,3'-dimethyl-5,5'-diethyl-diphenylmethan (70) | 4,4'-Diamino-trans-stilben-2,2'-disulfonsäure-tetrabutylammoniumsalz (30) | 3,4,3',4'-Benzophenon-tetracarbonsäuredianhydrid | 0,79 | 274 / - |
| A7 | 4,4'-Diamino-3,3'-dimethyl-5,5'-diethyl-diphenylmethan (90) | 4,4'-Diamino-trans-stilben-2,2'-disulfonsäure-tetrabutylammoniumsalz (10) | 3,4,3',4'-Benzophenon-tetracarbonsäuredianhydrid | 0,63 | 303 / - |
| A8 | 4,4'-Diamino-biphenyl-2,2'-disulfonsäure-ditetrabutyl-ammoniumsalz (10) | 4,4'-Diamino-3,3'-Diethyl-5,5'-Dimethyl-diphenylmethan (90) | 3,4,3',4'-Benzophenon-tetracarbonsäuredianhydrid (100) | 0,553 | 311/- |

Tabelle 1: Fortsetzung

| Beispiel Nr. | Diamin 1[1] (Mol-%) | Diamin 2[1] (Mol-%) | Tetracarbonsäure-dianhydrid | Inhärente[2] Viskosität (dl/g) | $T_g$[3]/ $T_m$[4] (°C) |
|---|---|---|---|---|---|
| A9 | 4,4'-Diamino-trans-stilben-2,2'-disulfonsäure-di-tetra-butyl-ammoniumsalz (20) | 4,4'-Diamino-3,3'-Diethyl-5,5'-Dimethyl-diphenylmethan (80) | 2,4-Bis-(phthal-säureanhydrid-4'-carbonyl) benzoe-säure (100) | 0,170 | 227/- |
| A10 | 4,4'-Diamino-trans-stilben-2,2'-disulfonsäure-di-tetra-butyl-ammoniumsalz (20) | 4,4'-Diamino-3,3'-Diethyl-5,5'-Dimethyl-diphenylmethan (80) | 4-(Pyromellitsäure-dianhydrid-3'-carbonyl)-benzophenon (100) | 0,387 | - |
| A11[5] | 4-4'-Diamino-trans-stilben-2,2'-disulfonsäu-re-di-tetra-bu-tyl-ammoniumsalz (10) | 4,4'-Diamino-3,3'-Diethyl-5,5'-Dimethyl-diphenylmethan (90) | Bicyclo[2.2.2]oct-7-en-2,3,5,6-tetra-carbonsäuredian-hydrid (20) | 0,162 | - |
| A12[6] | 4,4'-Diamino-trans-stilben-2,2'-disulfonsäu-re-di-tetra-bu-tyl-ammoniumsalz (10) | 2,4,6-Trimethyl-m-phenylendiamin (90) | Diethylentriamin penta-essigsäure-dianhydrid (10) | 0,373 | - |

Tabelle 1: Fortsetzung

| Beispiel Nr. | Diamin 1[1] (Mol-%) | Diamin 2[1] (Mol-%) | Tetracarbonsäure-dianhydrid | Inhärente[2] Viskosität (dl/g) | $T_g$[3]/ $T_m$[4] (°C) |
|---|---|---|---|---|---|
| A13[6] | 4,4'-Diamino-trans-stilben-2,2'-disulfonsäure-di-tetra-butyl-ammoniumsalz (10) | 4,4'-Diamino-3,3'-Diethyl-5,5'-Dimethyl-diphenylmethan (90) | Diethylentriamin penta-essigsäure-dianhydrid (10) | 0,386 | |
| A14[6] | 3,5-Diamino-2,4,6-trimethylbenzol-1-sulfonsäuretetra-butylammonium-salz (20) | 4,4'-Diamino-3,3'-Diethyl-5,5'-Dimethyl-diphenylmethan (80) | Tetrahydrofuran-2,3,4,5,-tetracar-bonsäure-dianhy-drid (10) | 0,873 | 300/- |

1) Bezogen auf die Diamine
2) 0,5 Gewichtsprozent in N-Methylpyrrolidon, 25°C
3) Glasumwandlungstemperatur (Differential-Scanning-Calometrie)
4) Schmelzpunkt (Differential-Scanning-Calometrie)
5) 2. Tetracarbonsäure-dianhydrid: 80 Mol-% 3,4,3',4'-Benzo-phenon-tetracarbonsäure-dianhydrid
6) 2. Tetracarbonsäure-dianhydrid: 90 Mol.-% 3,4,3',4'-Benzophenon-tetracarbonsäure-dianhydrid

B) Permeationsversuche

Beispiele B1 bis B7:

In der Mitte einer Druckzelle wird die Membran (Durchmesser 4,7 cm, Dicke 25 µm) in der Halterung befestigt. Jede Kammer ist mit einem Reservoir für die Lösung bzw. das reine Lösungsmittel verbunden, an die eine Pumpe angeschlossen ist. Zwischen Reservoirs und Pumpen befinden sich Leitfähigkeitszellen und -detektoren und zwischen Auslauf und Reservoirs befinden sich UV-Detektoren. Auf der Seite mit der Lösung wird ein Druck von 2,5 MPa und auf der Seite mit dem Lösungsmittel ein Druck von 0,3 MPa eingestellt und die Lösung sowie das Lösungsmittel in gleicher Richtung zirkuliert. Die Detektoren messen kontinuierlich die Leitfähigkeit und UV-Absorption. Die Auswertung der Messdaten erfolgt mittels eines Computerprogramms. Die Detektoren werden jeweils mit der organischen Verbindung (Zimtsäuremethylester) und dem Salz der Carbonsäure (Lithiumsalz der Zimtsäure) geeicht und die Eichkurven in Algorithmen umgewandelt, aus denen die gewünschten Daten errechnet werden. Als Lösungsmittel wird Methanol verwendet und die UV-Detektion wird bei 305 nm vorgenommen. Die Temperatur beträgt 25 °C.

Die Selektivität S ist wie folgt definiert, wobei $G^P$ Gewichtsanteil im Permeat und $G^L$ Gewichtsanteil in der Lösung bedeutet:

$$S = \frac{G^P \text{ (unpolarere organische Verbindung)}/G^P \text{ (Salz der Carbonsäure)}}{G^L \text{ (unpolarere organische Verbindung)}/G^L \text{ (Salz der Carbonsäure)}}$$

Weitere Angaben sind in der nachfolgenden Tabelle 2 enthalten.

Tabelle 2:

| Beispiel Nr. | Copolyimid von Beispiel | Permeations-geschwindigkeit ($mg \cdot min^{-1} \cdot cm^{-2}$) | Mengen am Versuchsbeginn [1] | | Versuchs-dauer (min) | permeierte Mengen am Versuchsende | | Selektivität |
|---|---|---|---|---|---|---|---|---|
| | | | Zimtsäure-methylester (mg) | Li-Cinna-mat (mg) | | Zimtsäure-methylester (mg) | Li-Cinna-mat (mg) | |
| B1 | A5 | 1,220 | 25 | 25 | 3780 | 6,40 | 1,69 | 3,80 |
| B2 | A6 | 0,617 | 25 | 25 | 3060 | 2,71 | 0,32 | 8,38 |
| B3 | A7 | 0,228 | 25 | 25 | 4050 | 0,51 | 0,14 | 3,64 |
| B4 | A8 | 0,095 | 75[2] | 75[3] | 1020 | 0,240[2] | 0,024[3] | 10,0 |
| B5 | A8 | 0,095 | 25 | 25 | 3060 | 0,412 | 0,130 | 3,2 |
| B6 | A14 | 0,254 | 25 | 25 | 1020 | 0,379 | 0,138 | 2,8 |
| B7 | A14 | 0,254 | 75[4] | 75[5] | 1020 | 2,511[4] | 0,028[5] | 90,3 |

1) 0,005 Gew.-%
2) Dimethylphthalat
3) 35 % Trimellitsäure-tri-Li-Salz und 65 % Trimellitsäure-di-Li-Salz
4) Methylbenzoat
5) 98 % Phthalsäure-di-Li-Salz und 2 % Phthalsäure-mono-Li-Salz

C) Belichtungsbeispiele

Beispiel C1: Das Copolyimid gemäss Beispiel A3 wird in N-Methylpyrrolidon gelöst (10 Gew.-%) und damit ein Kupferlaminat mit einem 12 µ Rakel beschichtet (Spincoating) und bei 100 °C getrocknet. Danach belichtet man unter einer Photomaske (Stouffer-Keil) während 30 Sekunden mit einer Leistung von 40 $mW/cm^2$ (Lampe: Ultralux 5000 H, Distanz 70 cm). Danach wird mit wässriger 1n NaOH entwickelt. Die Stoufferstufe 7 ist noch gut abgebildet.

Beispiel C2: Mit dem Copolyimid gemäss Beispiel A2 wird wie in Beispiel C1 verfahren. Die Stoufferstufe 8 ist noch gut abgebildet.

## Patentansprüche

1. Copolyimide mit einer inhärenten Viskosität von 0,2 bis 3,0 dl/g, gemessen bei 25 °C in einer Lösung von 0,5 Gew.-% des Copolyimids in N-Methylpyrrolidon, enthaltend
   A) mindestens ein wiederkehrendes Strukturelement aus aromatischen Tetracarbonsäureresten (a) mit 10 bis 30 C-Atomen, die unsubstituiert oder mit Halogen, Nitro, $C_1$-$C_4$-Alkyl, $C_1$-$C_4$-Alkoxy oder Phenacyl substituiert sind, und aromatischen Diaminresten (b) mit 6 bis 30 C-Atomen, die unsubstituiert oder mit $C_1$-$C_4$-Alkyl oder Halogen substituiert sind; und gegebenenfalls zusätzlich mindestens ein wiederkehrendes Strukturelement aus unsubstituierten oder wie (a) substituierten aromatischen Tricarbonsäureresten (c) mit 9 bis 30 C-Atomen und gleichen oder verschiedenen der genannten Diaminreste (b), und
   B) mindestens ein wiederkehrendes Strukturelement aus gleichen oder verschiedenen der genannten Tetracarbonsäurereste (a) und aromatischen Diaminresten (d) mit 6 bis 30 C-Atomen, die unsubstituiert oder mit $C_1$-$C_4$-Alkyl substituiert sind, und die mindestens eine an den aromatischen Kern gebundene $-SO_3M$-Gruppe enthalten, worin M für $H^{\oplus}$, ein ein- bis dreiwertiges Metallkation, $NH_4^{\oplus}$ oder ein organisches Ammoniumkation mit 1 bis 30 C-Atomen steht; und gegebenenfalls zusätzlich wiederkehrenden Strukturelementen aus gleichen oder verschiedenen der genannten Tricarbonsäurereste (c) und gleichen oder verschiedenen der besagten Diaminreste (d), mit der Massgabe, dass mindestens einer der Diaminreste (b) oder (d) in beiden Orthostellungen zu mindestens einem N-Atom mit $C_1$-$C_4$-Alkyl substituiert ist.

2. Copolyimide gemäss Anspruch 1, dadurch gekennzeichnet, dass die Diaminreste (b) in beiden Orthostellungen beider N-Atome mit $C_1$-$C_4$-Alkyl substituiert sind.

3. Copolyimide gemäss Anspruch 1, dadurch gekennzeichnet, dass die Diaminreste (d) in beiden Orthostellungen beider N-Atome mit $C_1$-$C_4$-Alkyl substituiert sind.

4. Copolyimide gemäss Anspruch 1, dadurch gekennzeichnet, dass die Diaminreste (b) und (d) in beiden Orthostellungen beider N-Atome mit Methyl und/oder Ethyl substituiert sind.

5. Copolyimide gemäss Anspruch 1, dadurch gekennzeichnet, dass sie 5 bis 95 Mol-% Komponente (A) und 95 bis 5 Mol-% Komponente (B) enthalten, bezogen auf das Copolyimid.

6. Copolyimide gemäss Anspruch 5, dadurch gekennzeichnet, dass sie 50 bis 95 Mol-% der Komponente (A) und 50 bis 5 Mol-% der Komponente (B) enthalten.

7. Copolyimide gemäss Anspruch 1, dadurch gekennzeichnet, dass sie
   a) Strukturelemente der Formel I

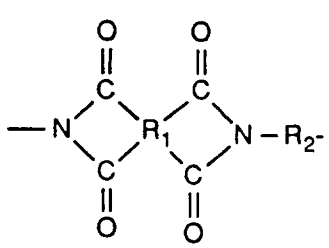

(I)

und gegebenenfalls zusätzlich Strukturelemente der Formel II

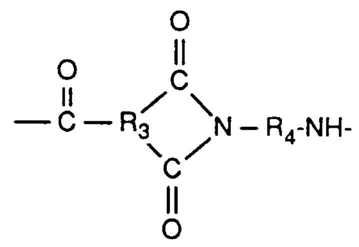

(II),

und

b) Strukturelemente der Formel III

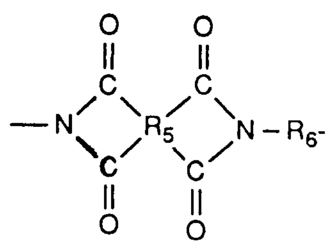

(III)

und gegebenenfalls zusätzlich Strukturelemente der Formel IV

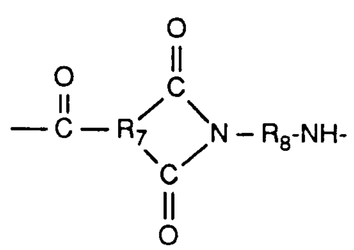

(IV)

enthalten, worin

$R_1$ und $R_5$ unabhängig voneinander einen unsubstituierten oder substituierten vierwertigen aromatischen Rest mit 6 bis 20 C-Atomen darstellen, an den je zwei der Carbonylgruppen in Ortho- oder Peristellung gebunden sind,

$R_3$ und $R_7$ unabhängig voneinander einen unsubstituierten oder substituierten trivalenten aromatischen Rest mit 6 bis 20 C-Atomen bedeuten, an den zwei Carbonylgruppen in Ortho- oder Peristellung gebunden sind,

$R_2$ und $R_4$ unabhängig voneinander einen zweiwertigen aromatischen Kohlenwasserstoffrest mit 6 bis 20 C-Atomen darstellen, der unsubstituiert oder mit $C_1$-$C_4$-Alkyl oder Halogen substituiert ist, und

$R_6$ und $R_8$ unabhängig voneinander einen zweiwertigen aromatischen Kohlenwasserstoffrest mit 6 bis 20 C-Atomen, die unsubstituiert oder mit $C_1$-$C_4$-Alkyl substituiert sind und die mindestens eine $-SO_3M$-Gruppe enthalten, worin M für $H^{\oplus}$, ein ein- bis dreiwertiges Metallkation, $NH_4^{\oplus}$ oder ein organisches Ammoniumkation mit 1 bis 30 C-Atomen steht, mit der Massgabe, dass die Reste $R_2$ und $R_4$ und/oder die Reste $R_6$ und $R_8$ in beiden Orthostellungen zu mindestens einem N-Atom mit $C_1$-$C_4$-Alkyl substituiert sind.

**8.** Copolyimide gemäss Anspruch 7, dadurch gekennzeichnet, dass $R_1$ und $R_5$ unabhängig voneinander Reste der Formeln

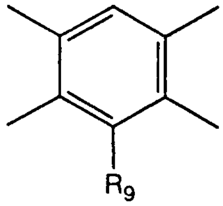 , 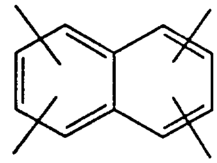 , 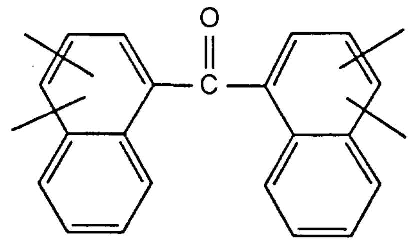 ,

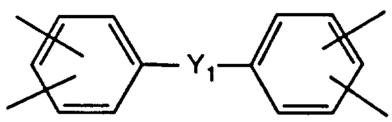 , 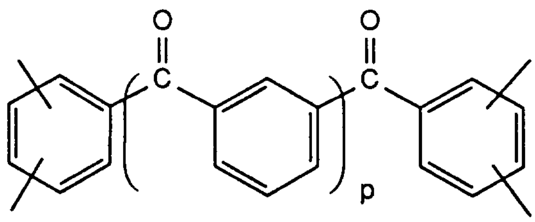 oder

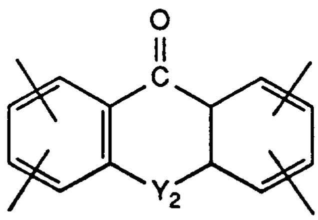

bedeuten, worin je zwei Bindungen in Orthostellung zueinander stehen, $R_9$ H oder Phenacyl darstellt, $Y_1$ für eine direkte Bindung, $-CH_2-$, $-CH(CH_3)-$, $-C(CH_3)_2-$, -O-, -S-, -SO-, $-SO_2-$, -C(O)O- oder $-NR_{10}-$ steht, p 0 oder 1 bedeutet, $Y_2$ $-CH_2-$, $-CH(CH_3)-$, $-C(CH_3)_2-$, -O-, -S-,-SO-, $-SO_2-$,-CO- oder $-NR_{10}-$ darstellt, und $R_{10}$ für H oder $C_1$-$C_6$-Alkyl steht.

**9.** Copolyimide gemäss Anspruch 7, dadurch gekennzeichnet, dass $R_1$ und $R_5$ unabhängig voneinander Reste der Formeln

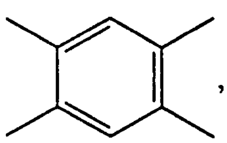 , 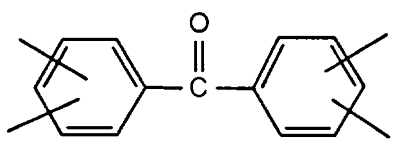 , 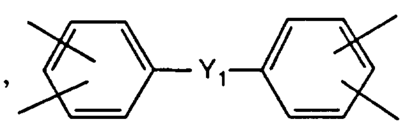 oder

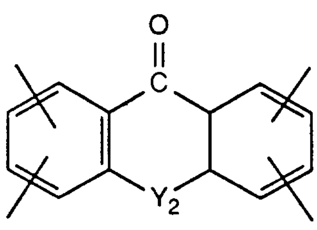

darstellen, worin je 2 Bindungen in Orthostellung zueinander stehen, $Y_1$ eine direkte Bindung, $-CH_2-$, -O-, -S- oder $-SO_2-$ bedeutet und $Y_2$ eine direkte Bindung -O-, -S- oder -CO- darstellt.

**10.** Copolyimide gemäss Anspruch 7, dadurch gekennzeichnet, dass $R_3$ und $R_7$ unabhängig voneinander Reste der Formeln

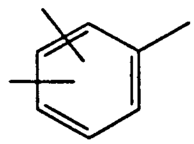 oder 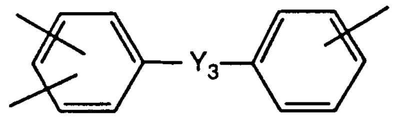

darstellen, worin zwei Bindungen in Orthostellung zueinander gebunden sind und $Y_3$ für eine direkte Bindung, -S-, -O-, $-CH_2-$ oder -CO- steht.

**11.** Copolyimide gemäss Anspruch 7, dadurch gekennzeichnet, dass die Tetracarbonsäurereste $R_1$ und $R_5$ und die Tricarbonsäurereste $R_3$ und $R_7$ eine Benzophenongruppe enthalten.

**12.** Copolyimide gemäss Anspruch 7, dadurch gekennzeichnet, dass es sich bei $R_2$, $R_4$, $R_6$ und $R_8$ um einen Phenylenrest, Naphthylenrest oder um einen gegebenenfalls verbrückten Biphenylenrest handelt.

**13.** Copolyimide gemäss Anspruch 7, dadurch gekennzeichnet, dass $R_2$ und $R_4$ unabhängig voneinander einen unsubstituierten oder mit Cl, Br oder $C_1$-$C_4$-Alkyl substituierten Rest der Formeln

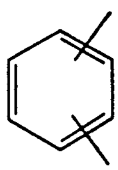 , 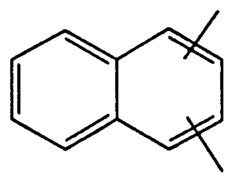 , 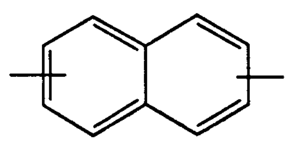 , 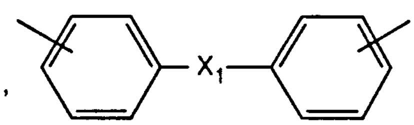

bedeuten, worin $X_1$ für eine direkte Bindung $-CH_2-$, $-(CH_2)_2-$, -HC=CH-, $CH_3CH<$ , $(CH_3)_2C<$ , $-NR_{10}-$, -N=N-, -CO-, -O-, -S-, -SO- oder $-SO_2-$ steht, und $R_{10}$ H oder $C_1$-$C_6$-Alkyl bedeutet und $R_6$ und $R_8$ unabhängig voneinander einen Rest der Formeln

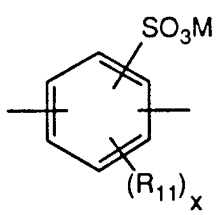 , 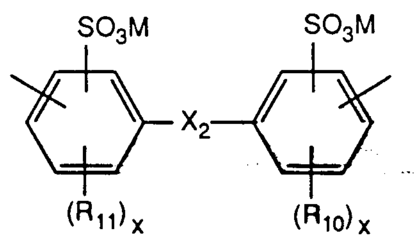

darstellen, worin $X_2$ unabhängig die gleiche Bedeutung wie $X_1$ hat, $R_{11}$ für $C_1$-$C_4$-Alkyl steht, x für 0, 1, 2 oder 3 steht und M für $H^{\oplus}$, $NH_4^{\oplus}$, ein Alkalimetallkation oder ein primäres, sekundäres, tertiäres oder quaternäres Ammoniumkation mit 1 bis 24 C-Atomen steht.

**14.** Copolyimide gemäss Anspruch 13, dadurch gekennzeichnet, dass es sich um ein Copolyimid mit Strukturelementen der Formeln I und III handelt, und $X_1$ und $X_2$ unabhängig voneinander eine direkte Bindung, $-CH_2-$, -CH=CH-, -CO-, -O- oder -S-bedeuten.

**15.** Copolyimide gemäss Anspruch 8, dadurch gekennzeichnet, dass in den Strukturelementen der Formeln I und II des Copolyimids $R_1$ und $R_5$ unabhängig voneinander für einen unsubstituierten oder mit Phenacyl, $-NO_2$, -Cl oder -Br substituierten vierwertigen Benzolrest oder Reste der Formeln

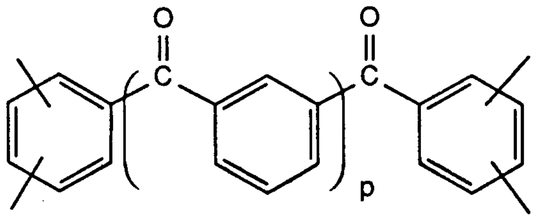 oder 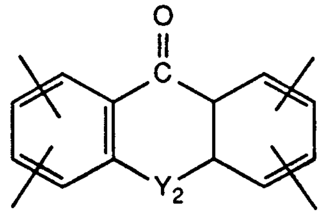

stehen, worin p für 0 oder 1 steht und $Y_2$ eine direkte Bindung, $-CH_2-$, -S-, -O- oder -CO-darstellen, $R_2$ in beiden Orthostellungen zu mindestens einer Aminogruppe mit Methyl und/oder Ethyl substituiertes 1,3- oder 1,4-Phenylen oder in beiden o-Stellungen zu den Aminogruppen mit Methyl und/oder Ethyl substituiertes 3,3'- oder 4,4'-Diphenylmethandiyl bedeutet, und $R_6$ einen Rest der Formeln

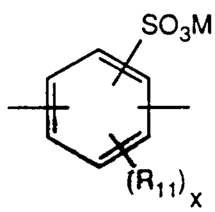 , 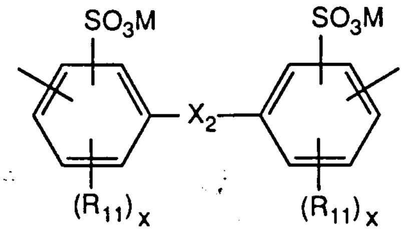

darstellt, worin $X_2$ eine direkte Bindung, -CH=H- oder $-CH_2-$ bedeutet, $R_{11}$ für Methyl und/oder Ethyl steht, x für 0, 1, 2 oder 3 steht, und M für $H^{\oplus}$, $NH_4^{\oplus}$, $Li^{\oplus}$, $Na^{\oplus}$, $K^{\oplus}$, $Rb^{\oplus}$, $Cs^{\oplus}$, primäres, sekundäres, tertiäres oder quaternäres Ammonium mit 1 bis 20 C-Atomen steht.

**16.** Copolyimide gemäss Anspruch 15, dadurch gekennzeichnet, dass $R_6$ ein Rest der Formeln

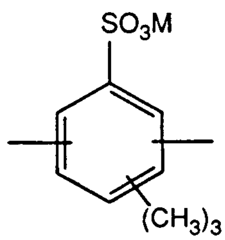 oder 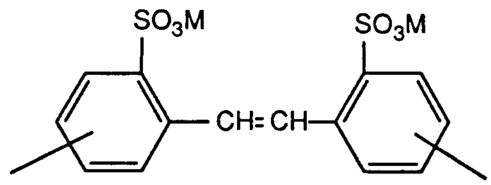

ist, worin M für $H^{\oplus}$, $NH_4^{\oplus}$, $Li^{\oplus}$, $Na^{\oplus}$, $K^{\oplus}$, $Rb^{\oplus}$, $Cs^{\oplus}$, tertiäres oder quaternäres Ammonium mit 4 bis 20 C-Atomen steht.

**17.** Verfahren zur Herstellung von Copolyimiden gemäss Anspruch 1, das dadurch gekennzeichnet ist, dass man,

A) mindestens eine aromatischen Tetracarbonsäure (a') mit 10 bis 30 C-Atomen, die unsubstituiert oder mit Halogen, Nitro, $C_1$-$C_4$-Alkyl, $C_1$-$C_4$-Alkoxy oder Phenacyl substituiert ist, und gegebenenfalls mindestens eine aromatische Tricarbonsäure (c') mit 9 bis 30 C-Atomen, die unsubstituiert oder wie (a') substituiert ist, oder deren Polyimid bildenden Derivate

B) mit mindestens einem aromatischen Diamin (b') mit 6 bis 30 C-Atomen, das unsubstituiert oder mit $C_1$-$C_4$-Alkyl oder Halogen substituiert ist, und und mit mindestens einem aromatischen Diamin (d') mit 6 bis 30 C-Atomen, das unsubstituiert oder mit $C_1$-$C_4$-Alkyl substituiert ist, und das mindestens eine an den aromatischen Kern gebundene $-SO_3M$-Gruppe enthält, mit der Massgabe, dass mindestens eines der Diamine (b') oder (d') in beiden Orthostellungen zu mindestens einer Aminogruppe mit $C_1$-$C_4$-Alkyl substituiert ist, umsetzt und cyclisiert.

**18.** Beschichtetes Material, enthaltend auf einem Träger eine Schicht eines Copolyimids gemäss Anspruch 1.

19. Verfahren zur Herstellung von Schutzschichten oder Reliefabbildungen, dadurch gekennzeichnet, dass man die Schicht des Materials gemäss Anspruch 18 flächenmässig bestrahlt, oder unter einer Photomaske bestrahlt und danach in einem wässrig-basischen Medium durch Lösen der unbestrahlten Anteile entwickelt.

20. Verfahren zum Anreichern oder Trennen von Salzen organischer Carbonsäuren von nicht salzartigen organischen Verbindungen mit einer semipermeablen Membran, dadurch gekennzeichnet, dass man eine Lösung der Salze und organischen Verbindungen in einem unsubstituierten oder mit $C_1$-$C_3$-Alkoxy substituierten $C_1$-$C_4$-Alkanol, Mischungen solcher Alkanole oder Mischungen solcher Alkanole mit Ethern mit einer Seite der Membran in Berührung bringt, wobei sich auf der Gegenseite der Membran das reine Lösungsmittel befindet, und die Membran aus einem Copolyimid gemäss Anspruch 1 besteht.

21. Verwendung von Copolyimiden gemäss Anspruch 1 zur Herstellung von Schutzschichten oder Reliefabbildungen.

22. Verwendung von Copolyimiden gemäss Anspruch 1 in Form von semipermeablen Membranen zum Anreichern oder Trennen von Salzen organischer Carbonsäuren von nichtsalzartigen organischen Verbindungen.

## Claims

1. A copolyimide having an inherent viscosity of 0.2 to 3.0 dl/g, measured at 25 °C in a solution of 0.5 % by weight of the copolyimide in N-methylpyrrolidone, and comprising
   A) at least one structural repeating unit of aromatic tetracarboxylic acid radicals (a) which contain 10 to 30 carbon atoms and which are unsubstituted or substituted by halogen, nitro, $C_1$-$C_4$alkyl, $C_1$-$C_4$alkoxy or phenacyl, and aromatic diamine radicals (b) which contain 6 to 30 carbon atoms and which are unsubstituted or substituted by $C_1$-$C_4$alkyl or halogen; and at least one additional optional structural repeating unit of aromatic tricarboxylic acid radicals (c) of 9 to 30 carbon atoms, which radicals are unsubstituted or substituted as for (a), and of identical or different diamine radicals (b) as mentioned above, and
   B) at least one structural repeating unit of identical or different tetracarboxylic acid radicals (a) as mentioned above and aromatic diamine radicals (d) which contain 6 to 30 carbon atoms and which are unsubstituted or substituted by $C_1$-$C_4$alkyl, and which contain at least one $-SO_3M$ group attached to the aromatic nucleus, wherein M is $H^{\oplus}$, a mono- to trivalent metal cation, $NH_4^{\oplus}$ or an organic ammonium cation of 1 to 30 carbon atoms; and additional optional structural repeating units of identical or different tricarboxylic acid radicals (c) as mentioned above and identical or different diamine radicals (d) as mentioned above, with the proviso that at least one of the diamine radicals (b) or (d) is substituted by $C_1$-$C_4$alkyl in both ortho-positions to at least one N atom.

2. A copolyimide according to Claim 1, wherein the diamine radicals (b) are substituted by $C_1$-$C_4$alkyl in both ortho-positions to both N atoms.

3. A copolyimide according to Claim 1, wherein the diamine radicals (d) are substituted by $C_1$-$C_4$alkyl in both ortho-positions to both N atoms.

4. A copolyimide according to Claim 1, wherein the diamine radicals (b) and (d) are substituted by methyl and/or ethyl in both ortho-positions to both N atoms.

5. A copolyimide according to Claim 1, which contains 5 to 95 mol % of component (A) and 95 to 5 mol % of component (B), based on the copolyimide.

6. A copolyimide according to Claim 5, which contains 50 to 95 mol % of component (A) and 50 to 5 mol % of component (B).

7. A copolyimide according to Claim 1, which comprises

a) structural units of the formula I

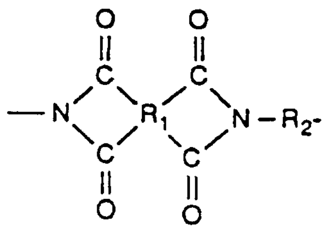

(I)

and additional optional structural units of the formula II

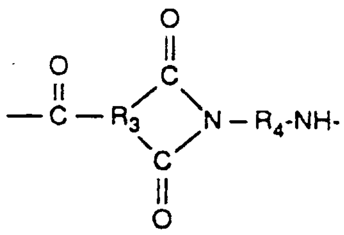

(II),

and

b) structural units of the formula III

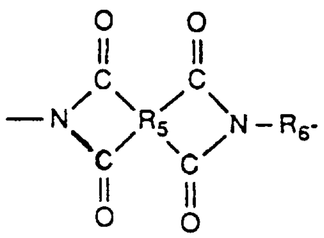

(III)

and additional optional structural units of the formula IV

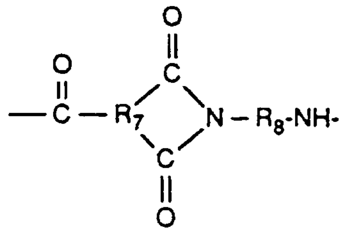

(IV)

wherein

$R_1$ and $R_5$ are each independently of the other an unsubstituted or substituted tetravalent aromatic radical of 6 to 20 carbon atoms, to each of which two of the carbonyl groups are attached, in ortho- or peri-position,

$R_3$ and $R_7$ are each independently of the other an unsubstituted or substituted trivalent aromatic radical of 6 to 20 carbon atoms, to which two carbonyl groups are attached, in ortho- or peri-position,

$R_2$ and $R_4$ are each independently of the other a divalent aromatic hydrocarbon radical of 6 to 20 carbon atoms which is unsubstituted or substituted by $C_1$-$C_4$alkyl or halogen, and

$R_6$ and $R_8$ are each independently of the other a divalent aromatic hydrocarbon radical of 6 to 20 carbon atoms, which are unsubstituted or substituted by $C_1$-$C_4$alkyl and which contain at least one $-SO_3M$ group, wherein M is $H^{\oplus}$, a mono- to trivalent metal cation, $NH_4^{\oplus}$ or an organic ammonium cation of 1 to 30 carbon atoms, with the proviso that the radicals $R_2$ and $R_4$ and/or the radicals $R_6$

and $R_8$ are substituted by $C_1$-$C_4$alkyl in both ortho-positions to at least one N atom.

**8.** A copolyimide according to Claim 7, wherein $R_1$ and $R_5$ are each independently of the other radicals of the formula

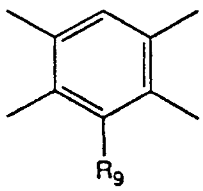 , 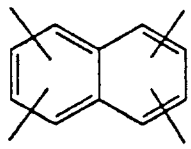 , 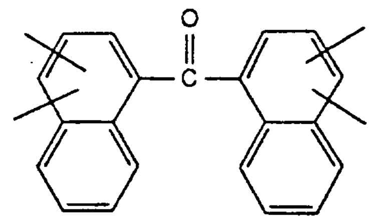 ,

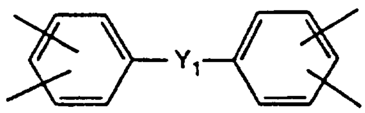 , 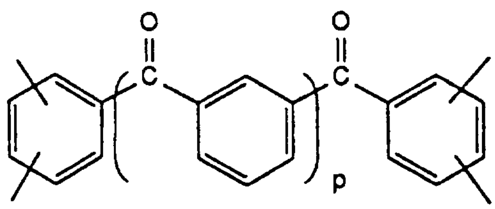 or

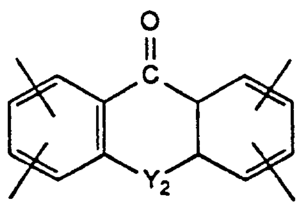 .

wherein in each case two bonds are in ortho-position to each other, $R_9$ is H or phenacyl, $Y_1$ is a direct bond, $-CH_2-$, $-CH(CH_3)-$, $-C(CH_3)_2-$, -O-, -S-, -SO-, $-SO_2-$, -C(O)O- or $-NR_{10}-$, p is 0 or 1, $Y_2$ is $-CH_2-$, $-CH(CH_3)-$, $-C(CH_3)_2-$, -O-, -S-, -SO-, $-SO_2-$, -CO- or $-NR_{10}-$, and $R_{10}$ is H or $C_1$-$C_6$alkyl.

**9.** A copolyimide according to Claim 7, wherein $R_1$ and $R_5$ are each independently of the other radicals of the formula

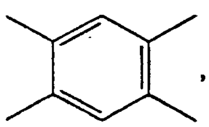 , 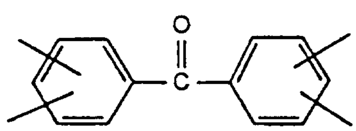 , 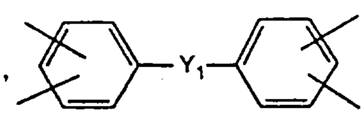 or

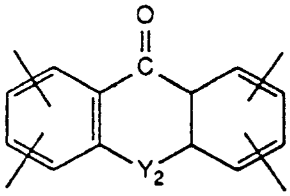 .

wherein in each case 2 bonds are in ortho-position to each other, $Y_1$ is a direct bond, $-CH_2-$, -O-, -S- or $-SO_2-$ and $Y_2$ is a direct bond, -O-, -S-or -CO-.

**10.** A copolyimide according to Claim 7, wherein $R_3$ and $R_7$ are each independently of the other radicals of the formula

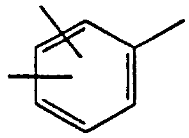 or 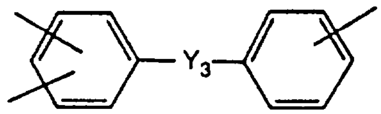

wherein two bonds are attached in ortho-position to each other, and $Y_3$ is a direct bond, -S-, -O-, $-CH_2-$ or -CO-.

**11.** A copolyimide according to Claim 7, wherein the tetracarboxylic acid radicals $R_1$ and $R_5$ and the tricarboxylic acid radicals $R_3$ and $R_7$ contain a benzophenone group.

**12.** A copolyimide according to Claim 7, wherein $R_2$, $R_4$, $R_6$ and $R_8$ are preferably a phenylene, naphthylene or an unbridged or bridged biphenylene radical.

**13.** A copolyimide according to Claim 7, wherein $R_2$ and $R_4$ are each independently of the other an unsubstituted or a Cl-, Br- or $C_1$-$C_4$-alkyl-substituted radical of the formulae

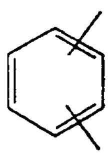, 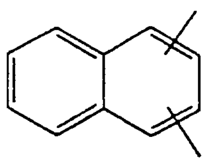, 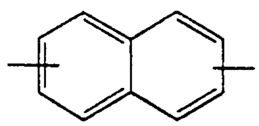, 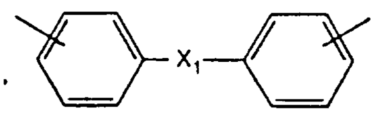

wherein $X_1$ is a direct bond, $-CH_2-$, $-(CH_2)_2$, -HC=CH-, $CH_3CH<$, $(CH_3)_2C<$, $-NR_{10}-$, -N=N-, -CO-, -O-, -S-, -SO- or $-SO_2$, and $R_{10}$ is H or $C_1$-$C_6$alkyl, and
$R_6$ and $R_8$ are each independently of the other a radical of the formula

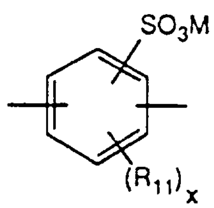, 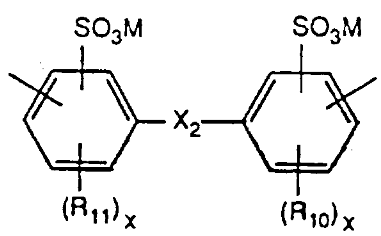

wherein $X_2$ independently has the same meaning as $X_1$, $R_{11}$ is $C_1$-$C_4$alkyl, x is 0, 1, 2 or 3, and M is $H^{\oplus}$, $NH_4^{\oplus}$, an alkali metal cation or a primary, secondary, tertiary or quaternary ammonium cation of 1 to 24 carbon atoms.

**14.** A copolyimide according to Claim 13, which comprises structural units of the formulae I and III, and wherein $X_1$ and $X_2$ are each independently of the other a direct bond, $-CH_2-$, -CH=CH-, -CO-, -O- or -S-.

**15.** A copolyimide according to Claim 8, which comprises structural units of the formulae I and II, wherein $R_1$ and $R_5$ are each independently of the other a tetravalent benzene radical which is unsubstituted or substituted by phenacyl, $-NO_2-$, -Cl or -Br, or a radical of the formula

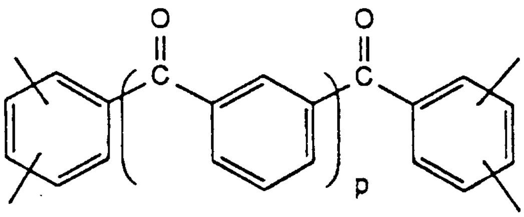 or 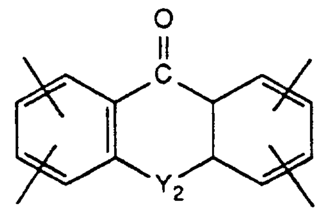

wherein p is 0 or 1 and $Y_2$ is a direct bond, $-CH_2-$, -S-, -O- or -CO-, $R_2$ in both ortho-positions to at least one amino group is methyl- and/or ethyl-substituted 1,3- or 1,4-phenylene, or in both o-positions to the amino groups is methyl- and/or ethyl-substituted 3,3' - or 4,4' - diphenylmethanediyl, and $R_6$ is a radical of the formula

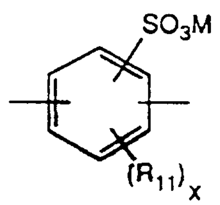 , 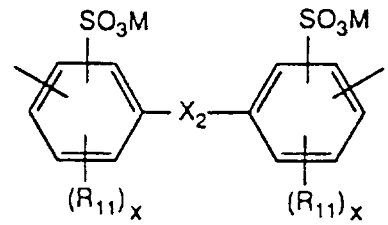

wherein $X_2$ is a direct bond. -CH=CH- or $-CH_2-$, $R_{11}$ is methyl and/or ethyl, x is 0, 1, 2 or 3, and M is $H^{\oplus}$, $NH_4^{\oplus}$, $Li^{\oplus}$, $Na^{\oplus}$, $K^{\oplus}$, $Rb^{\oplus}$, $Cs^{\oplus}$, primary, secondary, tertiary or quaternary ammonium of 1 to 20 carbon atoms.

**16.** A copolyimide according to Claim 15, wherein $R_6$ is a radical of the formula

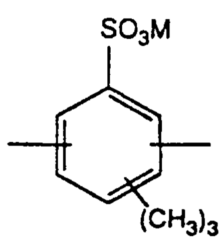 or 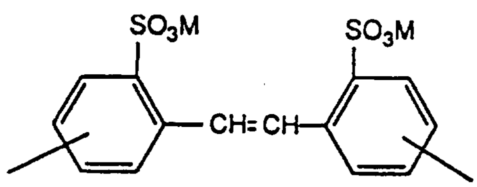

wherein M is $H^{\oplus}$, $NH_4^{\oplus}$, $Li^{\oplus}$, $Na^{\oplus}$, $K^{\oplus}$, $Rb^{\oplus}$, $Cs^{\oplus}$, tertiary or quaternary ammonium of 4 to 20 carbon atoms.

**17.** A process for the preparation of a copolyimide according to Claim 1, which comprises

A) reacting and cyclizing at least one aromatic tetracarboxylic acid (a') of 10 to 30 carbon atoms, which is unsubstituted or substituted by halogen, nitro, $C_1$-$C_4$alkyl, $C_1$-$C_4$alkoxy or phenacyl, and at least one optional aromatic tricarboxylic acid (c') of 9 to 30 carbon atoms, which is unsubstituted or substituted as for (a'), or a polyimide-forming derivative thereof,

B) with at least one aromatic diamine (b') of 6 to 30 carbon atoms, which is unsubstituted or substituted by $C_1$-$C_4$alkyl or halogen, and with at least one aromatic diamine (d') of 6 to 30 carbon atoms, which is unsubstituted or substituted by $C_1$-$C_4$alkyl, and which contains at least one $-SO_3M$ group attached to the aromatic nucleus, with the proviso that at least one of the diamines (b') or (d') is substituted by $C_1$-$C_4$alkyl in both ortho- positions to at least one amino group.

**18.** Coated material comprising on a support a layer of a copolyimide according to Claim 1.

**19.** A process for the production of protective layers or relief images, which comprises irradiating the layer of the material over the surface or through a photomask, and thereafter developing it according to Claim 18 in an aqueous alkaline medium by dissolving the nonirradiated areas.

**20.** A process for concentrating or separating salts of organic carboxylic acids from organic compounds of non-salt character with the aid of a semipermeable membrane, which process comprises bringing a solution of the salts and organic compounds in an unsubstituted or $C_1$-$C_3$alkoxy-substituted $C_1$-$C_4$alkanol, mixtures of such alkanols or mixtures of such alkanols with ethers, into contact with one side of the membrane, the pure solvent being present on the other side of the membrane and the membrane being made from a copolyimide according to Claim 1.

**21.** Use of a copolyimide according to Claim 1 for the production of protective layers or relief images.

**22.** Use of a copolyimide according to Claim 1 in the form of a semipermeable membrane for concentrating or separating salts of organic carboxylic acids from organic compounds of non-salt character.

**Revendications**

**1.** Copolyimides ayant une viscosité intrinsèque de 0,2 à 3,0 dl/g, mesurée à 25 °C dans une solution à 0,5 % en masse du copolyimide dans de la N-méthylpyrrolidone, contenant

A) au moins une unité constitutive récurrente formée à partir de restes d'acides tétracarboxyliques aromatiques (a) de 10 à 30 atomes de carbone, non substitués ou substitués par des restes halogène, nitro, alkyle en $C_1$-$C_4$, alcoxy en $C_1$-$C_4$ ou phénacyle, et de restes de diamines aromatiques (b) de 6 à 30 atomes de carbone non substituées ou substituées par des restes alkyle en $C_1$-$C_4$ ou halogène; et éventuellement en outre au moins une unité constitutive récurrente formée à partir de restes d'acides tricarboxyliques aromatiques (c) de 9 à 30 atomes de carbone non substitués ou substitués comme (a) et de restes, identiques ou différents, des diamines (b) précitées, et

B) au moins une unité constitutive récurrente formée à partir de restes, identiques ou différents, des acides tétracarboxyliques (a) précités, et de restes de diamines aromatiques (d) de 6 à 30 atomes de carbone, non substituées ou substituées par alkyle en $C_1$-$C_4$ et qui contiennent au moins un groupe $-SO_3M$ lié au noyau aromatique, dans lequel M signifie $H^{\oplus}$, un cation métallique mono- à trivalent, $NH_4^{\oplus}$ ou un cation d'ammonium organique de 1 à 30 atomes de carbone; et éventuellement en outre des unités constitutives récurrentes formées à partir de restes, identiques ou différents, des acides tricarboxyliques (c) précités, et de restes, identiques ou différents, des diamines (d) précitées, sous réserve qu'au moins l'un des restes de diamines (b) ou (d) soit substitué par un alkyle en $C_1$-$C_4$ dans les deux positions ortho par rapport à au moins un atome d'azote.

**2.** Copolyimides selon la revendication 1, caractérisés en ce que les restes de diamines (b) sont substitués par des restes alkyle en $C_1$-$C_4$ dans les deux positions ortho par rapport aux deux atomes d'azote.

**3.** Copolyimides selon la revendication 1, caractérisés en ce que les restes de diamines (d) sont substitués par des restes alkyle en $C_1$-$C_4$ dans les deux positions ortho par rapport aux deux atomes d'azote.

**4.** Copolyimides selon la revendication 1, caractérisés en ce que les restes de diamines (b) et (d) sont substitués par des restes méthyle et/ou éthyle dans les deux positions ortho par rapport aux deux atomes d'azote.

**5.** Copolyimides selon la revendication 1, caractérisés en ce qu'ils contiennent 5 à 95 % en moles de constituant (A) et 95 à 5 % en moles de constituant (B), par rapport au copolyimide.

**6.** Copolyimides selon la revendication 5, caractérisés en ce qu'ils contiennent 50 à 95 % en moles de constituant (A) et 50 à 5 % en moles de constituant (B).

**7.** Copolyimides selon la revendication 1, caractérisés en ce qu'ils contiennent

a) des unités constitutives de formule I

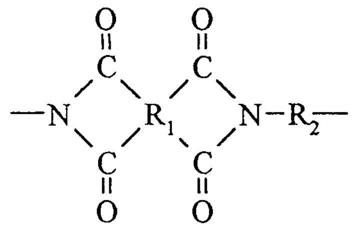

(I)

et éventuellement des unités constitutives additionnelles de formule II

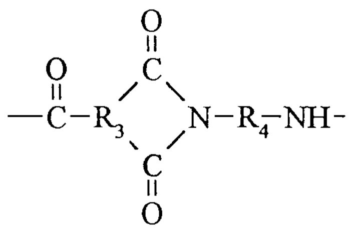

(II)

et
b) des unités constitutives de formule III

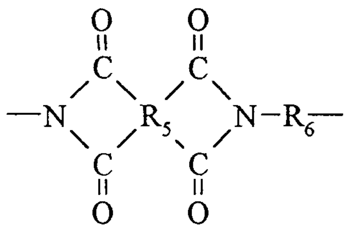

(III)

et éventuellement des unités constitutives additionnelles de formule IV

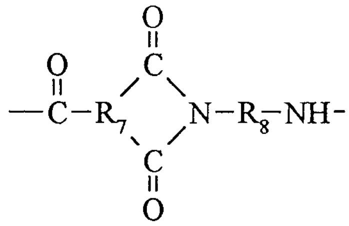

(IV)

dans lesquelles

$R_1$ et $R_5$ représentent indépendamment l'un de l'autre un reste aromatique tétravalent non substitué ou substitué de 6 à 20 atomes de carbone, auquel les groupes carbonyle sont liés deux à deux en position ortho ou péri,

$R_3$ et $R_7$ représentent indépendamment l'un de l'autre un reste aromatique trivalent non substitué ou substitué de 6 à 20 atomes de carbone, auquel sont liés deux groupes carbonyle en position ortho ou péri,

$R_2$ et $R_4$ représentent indépendamment l'un de l'autre un reste hydrocarboné aromatique divalent de 6 à 20 atomes de carbone, non substitué ou substitué par des restes alkyle en $C_1$-$C_4$ ou halogène, et

$R_6$ et $R_8$ représentent indépendamment l'un de l'autre un reste hydrocarboné aromatique divalent de 6 à 20 atomes de carbone non substitué ou substitué par alkyle en $C_1$-$C_4$, et qui contient

au moins un groupe $SO_3M$, où M représente $H^{\oplus}$, un cation métallique mono- à trivalent, $NH_4^{\oplus}$ ou un cation ammonium organique de 1 à 30 atomes de carbone, sous réserve que les restes $R_2$ et $R_4$ et/ou les restes $R_6$ et $R_8$ soient substitués par un alkyle en $C_1$-$C_4$ dans les deux positions ortho par rapport à au moins un atome d'azote.

**8.** Copolyimides selon la revendication 7, caractérisés en ce que $R_1$ et $R_5$ représentent indépendamment l'un de l'autre des restes ayant les formules

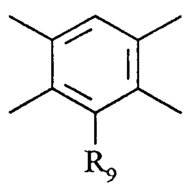 , 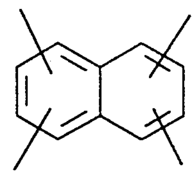 , 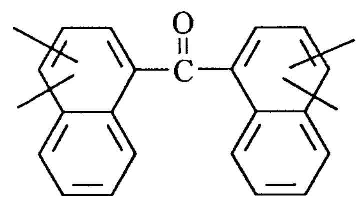 ,

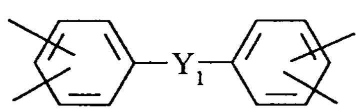 , 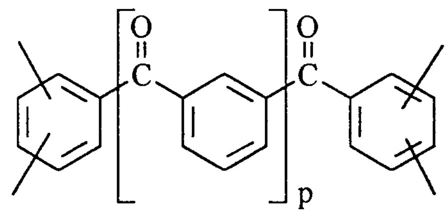 ou

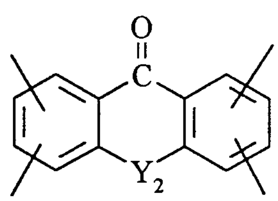 ,

dans lesquelles les liaisons sont deux à deux en position ortho les unes par rapport aux autres, $R_9$ représente H ou un reste phénacyle, $Y_1$ représente une liaison directe, $-CH_2-$, $-CH(CH_3)-$, $-C(CH_3)_2-$, -O-, -S-, -SO-, $-SO_2-$, -C(O)O- ou $-NR_{10}-$, p signifie 0 ou 1, $Y_2$ est $-CH_2-$, $-CH(CH_3)-$, $-C(CH_3)_2-$, -O-, -S-, -SO-, $-SO_2-$, -CO- ou $-NR_{10}-$, et $R_{10}$ est H ou un alkyle en $C_1$-$C_6$.

**9.** Copolyimides selon la revendication 7, caractérisés en ce que $R_1$ et $R_5$ représentent indépendamment l'un de l'autre des restes ayant les formules

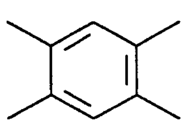 , 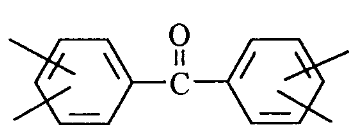 , 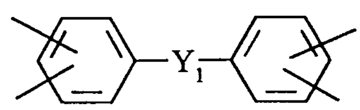 ou

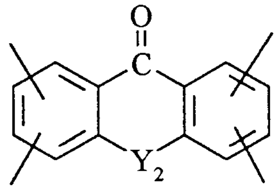 ,

dans lesquelles les liaisons sont deux à deux en position ortho les unes par rapport aux autres, $Y_1$ représente une liaison directe, $-CH_2-$, -O-, -S- ou $-SO_2-$, et $Y_2$ représente une liaison directe, -O-, -S- ou -CO-.

**10.** Copolyimides selon la revendication 7, caractérisés en ce que $R_3$ et $R_7$ représentent indépendamment l'un de l'autre des restes ayant les formules

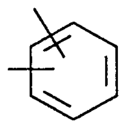 ou 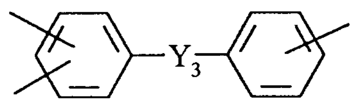

dans lesquelles deux liaisons sont liées en position ortho l'une par rapport à l'autre et $Y_3$ représente une liaison directe, -S-, -O-, $-CH_2-$ ou -CO-.

**11.** Copolyimides selon la revendication 7, caractérisés en ce que les restes d'acides tétracarboxyliques $R_1$ et $R_2$ et les restes d'acides tricarboxyliques $R_3$ et $R_7$ contiennent un groupe benzophénone.

**12.** Copolyimides selon la revendication 7, caractérisés en ce que, en ce qui concerne les restes $R_2$, $R_4$, $R_6$ et $R_8$, il s'agit de préférence de restes phénylène, de restes naphtylène ou de restes biphénylène éventuellement pontés.

**13.** Copolyimides selon la revendication 7, caractérisés en ce que $R_2$ et $R_4$ représentent, indépendamment l'un de l'autre, un reste non substitué ou substitué par Cl, Br ou alkyle en $C_1$-$C_4$ ayant les formules

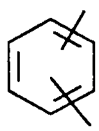 , 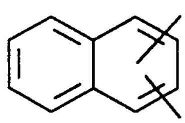 , 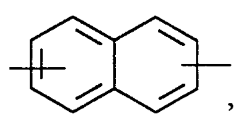 , 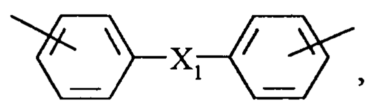 ,

dans lesquelles $X_1$ représente une liaison directe, $-CH_2-$, $-(CH_2)_2-$, $-HC=CH-$, $CH_3CH<$ , $(CH_3)_2C<$ , $-NR_{10}-$, -N=N-, -CO-, -O-, -S-, -SO- ou $-SO_2-$, et $R_{10}$ représente H ou un alkyle en $C_1$-$C_6$, et $R_6$ et $R_8$ représentent indépendamment l'un de l'autre un reste ayant les formules

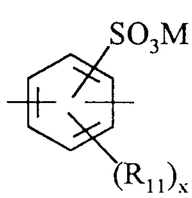 , 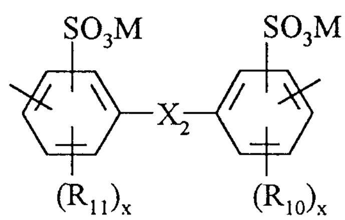 ,

dans lesquelles $X_2$ a indépendamment la même signification que $X_1$, $R_{11}$ représente un alkyle en $C_1$-$C_4$, x est 0, 1, 2 ou 3 et M représente $H^{\oplus}$, $NH_4^{\oplus}$, un cation de métal alcalin ou un cation ammonium primaire, secondaire, tertiaire ou quaternaire de 1 à 24 atomes de carbone.

**14.** Copolyimides selon la revendication 13, caractérisés en ce qu'il s'agit de copolyimides ayant des unités constitutives de formules I et III, et en ce que $X_1$ et $X_2$ représentent indépendamment l'un de l'autre une liaison directe, $-CH_2-$, -CH=CH-, -CO-, -O- ou -S-.

**15.** Copolyimides selon la revendication 8, caractérisés en ce que, dans les unités constitutives de formules I et III du copolyimide, $R_1$ et $R_5$ représentent indépendamment l'un de l'autre un reste benzène tétravalent non substitué ou substitué par phénacyle, $-NO_2$, -Cl ou -Br, ou des restes ayant les formules

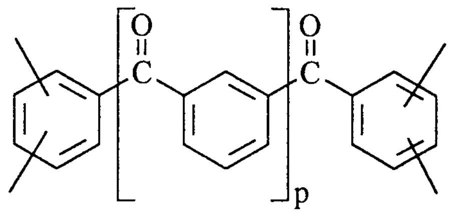 ou 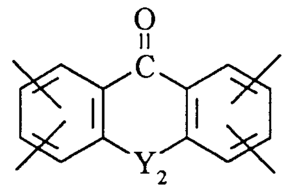

dans lesquelles p est 0 ou 1 et $Y_2$ représente une liaison directe, $-CH_2-$, -S-, -O- ou -CO-, $R_2$ représente un reste 1,3- ou 1,4-phénylène substitué par méthyle et/ou éthyle dans les deux positions ortho par rapport au moins un groupe amino, ou un reste 3,3'- ou 4,4'-diphiénylméthanediyle substitué par méthyle et/ou éthyle dans les deux positions ortho par rapport aux groupes amino, et $R_6$ représente un reste ayant les formules

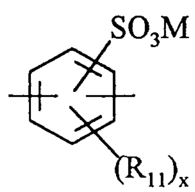 , 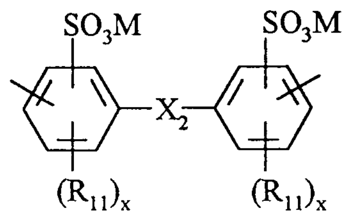 ,

dans lesquelles $X_2$ représente une liaison directe, -CH=CH- ou $-CH_2-$, $R_{11}$ est un méthyle et/ou un éthyle, x est 0, 1, 2 ou 3, et M représente $H^{\oplus}$, $NH_4^{\oplus}$, $Li^{\oplus}$, $Na^{\oplus}$, $K^{\oplus}$, $Rb^{\oplus}$, $Cs^{\oplus}$, ou un ammonium primaire, secondaire, tertiaire ou quaternaire de 1 à 20 atomes de carbone.

**16.** Copolyimides selon la revendication 15, caractérisés en ce que $R_6$ représente un reste ayant les formules

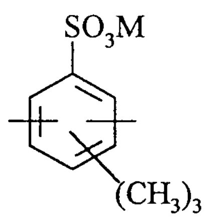 ou 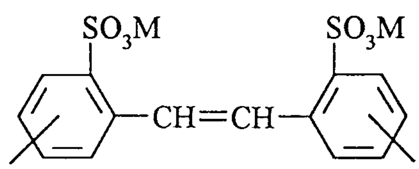

dans lesquelles M représente $H^{\oplus}$, $NH_4^{\oplus}$, $Li^{\oplus}$, $Na^{\oplus}$, $K^{\oplus}$, $Rb^{\oplus}$, $Cs^{\oplus}$, ou un ammonium tertiaire ou quaternaire de 4 à 20 atomes de carbone.

**17.** Procédé de préparation de copolyimides selon la revendication 1, caractérisé en ce que l'on fait réagir et on cyclise

A) au moins un acide tétracarboxylique aromatique (a') de 10 à 30 atomes de carbone, non substitué ou substitué par des restes halogène, nitro, alkyle en $C_1$-$C_4$, alcoxy en $C_1$-$C_4$ ou phénacyle, et éventuellement au moins un acide tricarboxylique aromatique (c') de 9 à 30 atomes de carbone, non substitué ou substitué comme (a'), ou leurs dérivés formant des polyimides, avec

B) au moins une diamine aromatique (b') de 6 à 30 atomes de carbone, non substituée ou substituée par des restes alkyle en $C_1$-$C_4$ ou halogène, et avec au moins une diamine aromatique (d') de 6 à 30 atomes de carbone, non substituée ou substituée par alkyle en $C_1$-$C_4$, et contenant au moins un groupe $SO_3M$ lié au noyau aromatique, sous réserve qu'au moins l'une des diamines (b') ou (d') soit substituée par alkyle en $C_1$-$C_4$ dans les deux positions ortho par rapport à au moins un groupe amino.

**18.** Matériau revêtu, contenant sur un support une couche d'un copolyimide selon la revendication 1.

**19.** Procédé de préparation de revêtements protecteurs ou d'images en relief, caractérisé en ce que l'on expose le revêtement du matériau selon la revendication 18 sur toute la surface ou sous un photomasque et on le révèle ensuite dans un milieu basique aqueux par dissolution des portions non exposées.

**20.** Procédé pour concentrer ou séparer des sels d'acides carboxyliques organiques à partir de mélanges avec des composés organiques non salins à l'aide d'une membrane semi-perméable, caractérisé en ce que l'on met en contact avec un côté de la membrane une solution des sels et des composés organiques dans un alcanol en $C_1$-$C_4$ non substitué ou substitué par un alcoxy en $C_1$-$C_3$, des mélanges de tels alcanols ou des mélanges de tels alcanols avec des éthers, le solvant pur se trouvant de l'autre côté de la membrane, et en ce que la membrane est constituée d'un copolyimide selon la revendication 1.

**21.** Utilisation de copolyimides selon la revendication 1 pour la préparation de revêtements protecteurs ou d'images en relief.

**22.** Utilisation de copolyimides selon la revendication 1 sous forme de membranes semi-perméables pour concentrer ou séparer des sels d'acides carboxyliques organiques à partir d'un mélange avec des composés organiques non salins.